# EUROPEAN PATENT APPLICATION

(11) **EP 4 838 231 A1**
(43) Date of publication of application: **11.11.2026**
(21) Application number: 25785504.9
(22) Date of filing: 07.03.2025
(51) Int. Cl.: G01R 31/00

(54) **HOME APPLICANCE AND POWER CONSUMPTION MONITORING METHOD**

(30) Priority: 12.04.2024 CN 202410441999; 13.05.2024 CN 202410591431
(71) Applicant: Hisense Refrigerator Co., Ltd., Qingdao, Shandong 266736 (CN)
(72) Inventor: CHEN, Hongxin, Qingdao, Shandong 266736 (CN)
(74) Representative: Petraz, Gilberto Luigi
(86) International application number: PCT/CN2025/081313
(87) International publication number: WO 2025/214024

(57) **Abstract**

Provided in the present application is a refrigerator, which comprises a plurality of functional components and a processing apparatus. The processing apparatus is configured to: on the basis of refrigerator operation condition information, use a preconfigured first model to determine a first energy-saving operation parameter value of at least one first functional component corresponding to the refrigerator operation condition information; replace an actual operation parameter value corresponding to a first energy-saving operation parameter in the refrigerator operation condition information with the first energy-saving operation parameter value, so as to obtain refrigerator energy-saving operation condition information; on the basis of the refrigerator energy-saving operation condition information, use a preconfigured second model to determine a second energy-saving operation parameter value of at least one second functional component corresponding to the refrigerator energy-saving operation condition information; and drive the operation of the first functional component on the basis of the first energy-saving operation parameter value, and drive the operation of the second functional component on the basis of the second energy-saving operation parameter value.

## Description

### CROSS-REFERENCE TO RELATED APPLICATIONS

This application claims priority to Chinese Patent Application No. 202410441999.7 filed on April 12, 2024 and Chinese Patent Application No. 202410591431.3 filed on May 13, 2024, the entire contents of which are incorporated herein by reference.

### TECHNICAL FIELD

The present application relates to the field of appliance equipment technologies, and in particular, to a home appliance and a power consumption monitoring method.

### BACKGROUND

Home appliances such as refrigerators bring great convenience to people's lives, but energy consumptions of the home appliances also become larger and larger. For example, the refrigerators are usually powered on and operate all day long, and cumulatively consumed electric energy cannot be underestimated. Therefore, users also pay more and more attention to the energy consumptions of the home appliances.

### SUMMARY

The present application provides a home appliance and a power consumption monitoring method, which realize optimization and an improvement of an efficiency of a refrigerator and reduce an energy consumption of a product.

In some embodiments, the home appliance may be a refrigerator.

In a first aspect, some embodiments of the present application provide a refrigerator, including a plurality of functional components and a processing apparatus, the processing apparatus being configured to:
on the basis of refrigerator operation condition information, use a preconfigured first model (also called a main training model) to determine a first energy-saving operation parameter value of at least one first functional component corresponding to the refrigerator operation condition information;
replace an actual operation parameter value corresponding to a first energy-saving operation parameter in the refrigerator operation condition information with the first energy-saving operation parameter value determined by the first model, so as to generate refrigerator energy-saving operation condition information;
on the basis of the refrigerator energy-saving operation condition information, use a preconfigured second model (also called an additional training model) to determine a second energy-saving operation parameter value of at least one second functional component corresponding to the refrigerator energy-saving operation condition information; and
drive operation of the first functional component on the basis of the first energy-saving operation parameter value, and drive operation of the second functional component on the basis of the second energy-saving operation parameter value.

The processing apparatus decomposes and processes an energy-saving setting task by using at least two models, the first model is configured to determine the energy-saving operation parameter of the first functional component, and the second model is configured to determine an energy-saving operation parameter of the second functional component. By means of the decomposition, the first model and the second model can be respectively focused on specific tasks, a learning prediction capability of each model is improved, the energy-saving setting task is decoupled and modularized through the first model and the second model, and meanwhile, a system is more flexible and extensible, a complex energy-saving optimization task can be better dealt with, and an energy-saving effect is improved.

In a second aspect, some embodiments of the present application provide a power consumption monitoring method of a home appliance, which is applied to a cloud server, the method including:
determining whether the home appliance is disconnected from a network in a current monitoring period;
if the home appliance is disconnected from the network in the current monitoring period, acquiring a plurality of first historical power consumptions;
inputting the plurality of first historical power consumptions into a fourth model to obtain a first power consumption of the current monitoring period, the fourth model being obtained by performing training according to a plurality of second historical power consumptions;
saving the first power consumption; and
determining an actual power consumption of the home appliance in a current preset period based on the first power consumption, wherein the current preset period includes the current monitoring period.

The method solves the problem that the calculated actual power consumption is inaccurate due to loss of an operation parameter during the network disconnection of the home appliance, so that a user can more accurately know the power consumption of the home appliance and adjust a use habit of the home appliance in time, so as to lower the energy consumption.

After reading of specific implementations of the present application with reference to the accompanying drawings, other characteristics and advantages of the present application will become more apparent.

### BRIEF DESCRIPTION OF THE DRAWINGS

In order to illustrate the technical solutions in the embodiments of the present application more clearly, the drawings required for describing the embodiments will be described briefly. Apparently, the following described drawings are merely for embodiments of the present application, and other drawings can be derived from the disclosed drawings by those of ordinary skill in the art without any creative effort.

In order to illustrate the technical solutions in the embodiments of the present application more clearly, the drawings required for describing the embodiments will be described briefly. Apparently, the following described drawings are for some embodiments of the present application, and other drawings can be derived from these drawings by those of ordinary skill in the art without any creative effort.
FIG. 1 is a schematic structural block diagram of a refrigerator according to some embodiments;
FIG. 2 is a schematic structural diagram of the refrigerator according to some embodiments;
FIG. 3 is a schematic structural block diagram of a processing apparatus in some embodiments;
FIG. 4 is a schematic structural block diagram of the refrigerator according to some embodiments;
FIG. 5 is a schematic structural block diagram of a refrigerator according to some other embodiments;
FIG. 6 is a flowchart of a refrigerator control method performed by a processing apparatus in some embodiments;
FIG. 7 is a flowchart of a refrigerator control method performed by a processing apparatus in some other embodiments;
FIG. 8 is a flowchart of a refrigerator control method performed by a processing apparatus in some other embodiments;
FIG. 9 is a flowchart of a refrigerator control method performed by a processing apparatus in some other embodiments;
FIG. 10 is a schematic structural diagram of a deployment model in a server in some embodiments;
FIG. 11 is a flowchart of the refrigerator control method performed by the processing apparatus in some embodiments;
FIG. 12 is a flowchart of the refrigerator control method performed by the processing apparatus in some embodiments;
FIG. 13 is a flowchart of the refrigerator control method performed by the processing apparatus in some embodiments;
FIG. 14 is a flowchart of the refrigerator control method performed by the processing apparatus in some embodiments;
FIG. 15 is a schematic flow diagram of a power consumption monitoring method of a home appliance according to an embodiment of the present application;
FIG. 16 is a schematic diagram of a monitoring period during operation of the home appliance in an example of the embodiment of the present application;
FIG. 17 is a schematic flow diagram of another power consumption monitoring method of a home appliance according to an embodiment of the present application;
FIG. 18 is a schematic flow diagram of still another power consumption monitoring method of a home appliance according to an embodiment of the present application;
FIG. 19 is a schematic flow diagram of still another power consumption monitoring method of a home appliance according to an embodiment of the present application;
FIG. 20 is a schematic flow diagram of still another power consumption monitoring method of a home appliance according to an embodiment of the present application;
FIG. 21 is a schematic flow diagram of still another power consumption monitoring method of a home appliance according to an embodiment of the present application;
FIG. 22 is a schematic structural diagram of a power consumption monitoring apparatus of a home appliance according to the present application; and
FIG. 23 is a schematic structural diagram of an electronic device according to an embodiment of the present application.

### DETAILED DESCRIPTION

The technical solutions in the embodiments of the present application are clearly and completely described with reference to the accompanying drawings in the embodiments of the present application, and apparently, the described embodiments are not all but only a part of the embodiments of the present application. All other embodiments obtained by a person of ordinary skill in the art based on the embodiments of the present application without creative efforts shall fall within the protection scope of the present application.

In descriptions of the present application, it should be understood that, directions or positional relationships indicated by terms "center", "upper", "lower", "front", "rear", "left", "right", "vertical", "horizontal", "top", "bottom", "inner", "outer", etc. are based on orientations or positional relationships shown in the accompanying drawings, and they are used only for describing the present application and for description simplicity, but do not indicate or imply that an indicated apparatus or element must have a specific orientation or be constructed and operated in a specific orientation. Therefore, it cannot be understood as a limitation on the present application.

The terms such as "first" and "second" are used herein for purposes of description and are not intended to indicate or imply relative importance or significance or to imply the number of indicated technical features. Thus, the feature defined with "first" and "second" may include one or more of this feature explicitly or implicitly. In the description of the present application, "a plurality of" means two or more unless otherwise stated.

In the description of the present application, it should be noted that unless specified or limited otherwise, the terms "mounted", "connected", and "coupled" and the like are used broadly, and may be, for example, fixed connections, detachable connections, or integral connections; may also be mechanical or electrical connections; may also be direct connections or indirect connections via intervening structures; may also be inner communications of two elements. The specific meanings of the above terms in the present disclosure can be understood by those of ordinary skill in the art according to specific cases.

In the present application, unless specified or limited otherwise, a structure in which a first feature is "on" or "below" a second feature may include an embodiment in which the first feature is in direct contact with the second feature, and may also include an embodiment in which the first feature and the second feature are not in direct contact but are contacted via an additional feature formed therebetween. Furthermore, a first feature "on," "above," or "on top of" a second feature may include an embodiment in which the first feature is right and obliquely "on," "above," or "on top of" the second feature, or just means that the first feature is at a height higher than that of the second feature. A first feature "below," "under," or "on bottom of" a second feature may include an embodiment in which the first feature is right and obliquely "below," "under," or "on bottom of" the second feature, or just means that the first feature is at a height lower than that of the second feature.

The term "and/or" in the present application only describes an association relationship between associated objects, and indicates that three relationships may exist. For example, A and/or B may indicate three cases: only A exists; both A and B exist; and only B exists. In addition, the character "/" herein indicates an "or" relationship between the associated objects.

The following disclosure provides many different embodiments or examples for implementing different features of the present application. In order to simplify the disclosure of the present application, components and arrangements of specific examples are described below. Certainly, they are merely examples and are not intended to limit the present application. In addition, the present application may repeat reference numerals and reference letters in different examples, which is for the purposes of simplicity and clarity and does not indicate a relationship between the various discussed implementations and configurations.

Home appliances such as refrigerators bring convenience to people's lives, but energy consumptions thereof become larger and larger, and users pay more and more attention to the energy consumptions of the home appliances. In order to reduce the energy consumptions, more and more home appliances are designed to save energy. For example, in the case of a refrigerator, energy saving is generally realized by adopting a high-efficiency compressor, thickening an insulating layer, using double door seals, using a vacuum insulation panel, or the like, but these measures increase a cost of the product and are not beneficial to environmental protection.

Based on this, the present application provides a home appliance. Based on operation condition information of the home appliance in an operation state, energy-saving operation parameters corresponding to a plurality of functional components are respectively determined by utilizing multiple models, and the corresponding functional components are controlled to operate according to the energy-saving operation parameters, so as to achieve the purpose of saving energy, reduce the cost of the product, and facilitate the environmental protection. The home appliance may include, but is not limited to, a refrigerator, an air conditioner, or the like.

The functional components refer to elements or components in the refrigerator which achieve various functions of the refrigerator under driving of electric power, such as a compressor, a fan, and a defrosting heater. The present application has no limitation on the functional components.

In the present application, an application principle of a method for determining the energy-saving operation parameters is the same in the home appliances such as the refrigerator and the air conditioner, and for convenience of description, a calculation solution of the present application is described below with reference to various embodiments with the refrigerator as an example, but the present application is not limited thereto.

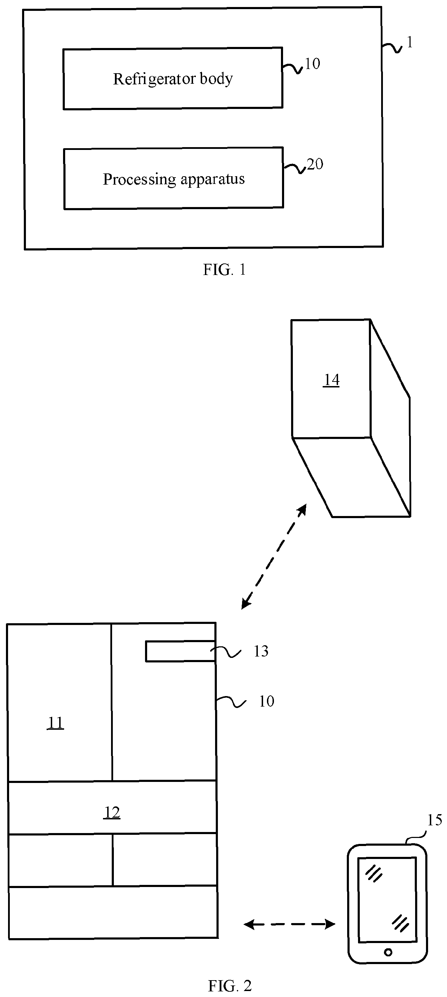

Hereinafter, a refrigerator 1 according to the present application is described with reference to the accompanying drawings, and in some embodiments, an overall structure of the refrigerator 1 is shown in FIG. 1.

The refrigerator 1 includes a refrigerator body 10. The refrigerator body 10 includes a cabinet configured to form an appearance of the refrigerator. The cabinet is provided therein with a storage compartment for storing articles. The refrigerator body 10 further includes various elements such as a refrigeration system for achieving the functions of the refrigerator. A structure of the refrigerator body 10 is described in detail with reference to the following embodiments.

In some embodiments, the refrigerator 1 further includes a processing apparatus 20. A structure and functions of the processing apparatus 20 are described in detail with reference to the following embodiments.

As shown in FIG. 2, the storage compartment is constructed in the refrigerator body 10.

The storage compartments typically include a freezing compartment and a refrigerating compartment. A temperature interval of the refrigerating compartment may be 0°C to 10°C (e.g., 4°C), so as to store food, drugs or biological agents in a refrigerating state. A temperature interval of the freezing compartment may be -15°C to -40°C (e.g., -18°C), so as to store food, drugs or biological agents in a freezing state. In some embodiments, the storage compartment may further include a variable temperature compartment. A temperature of the variable temperature compartment can be adjusted between the freezing temperature interval and the refrigerating temperature interval according to needs of a user, for example, a temperature range of the variable temperature compartment can be adjusted between 5°C and -20°C.

In some embodiments, if the storage compartment is classified according to a function thereof, the storage compartment can also include a fruit and vegetable compartment for storing fruits, vegetables, or the like.

The present application has no limitation on the type or arrangement of the storage compartment.

The refrigerator body 10 further includes a door 11, and the door 11 is rotatably coupled to the cabinet to open and close the storage compartment.

The storage compartment has an opening that can be opened and closed by the door 11, and can also be opened and closed by pushing or pulling a drawer 12 into or out of the opening. In some embodiments, the openings of some storage compartments are opened and closed by the door, and the openings of other storage compartments are opened and closed by pushing and pulling the drawers. For example, when the storage compartments include the refrigerating compartment and the freezing compartment, the opening of the refrigerating compartment is opened and closed by the door and the opening of the freezing compartment is opened and closed by the drawer 12.

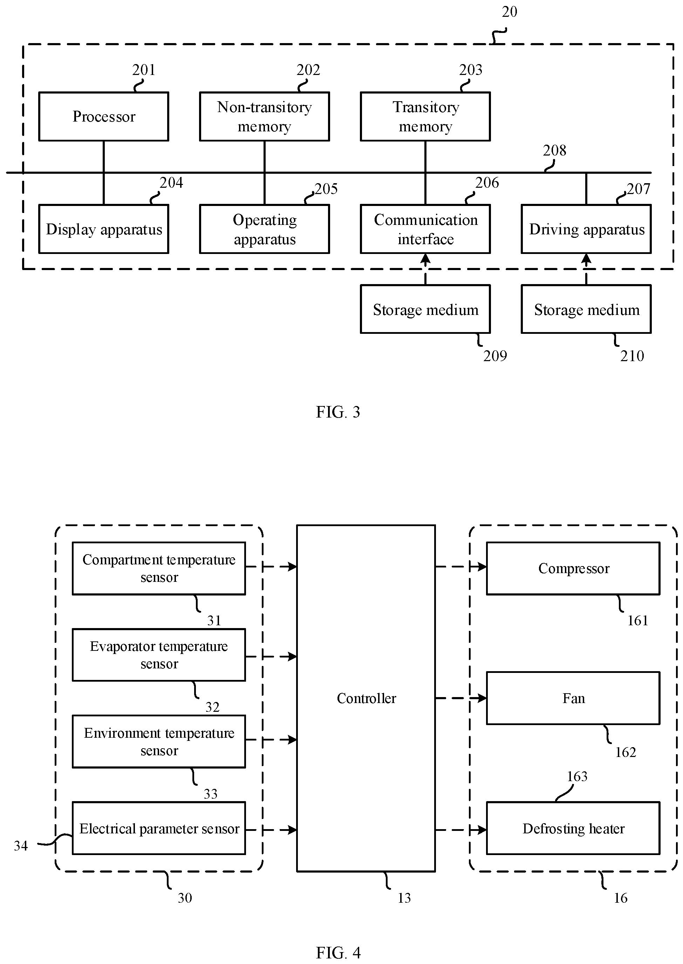

In some embodiments, a vapor compression refrigeration cycle system is adopted in the refrigerator body 10 to implement refrigeration of the refrigerator. The refrigeration cycle system includes a compressor 161 (referring to FIG. 4), a condenser, a throttling apparatus, and an evaporator.

In the vapor compression refrigeration cycle system, a low-temperature and low-pressure refrigerant enters the compressor 161, and is compressed into high-temperature and high-pressure refrigerant gas by the compressor 161. The high-temperature and high-pressure refrigerant gas flows into the condenser, the high-temperature and high-pressure refrigerant gas in the condenser is condensed into a liquid phase, and heat released in the condensation process is dissipated to a surrounding environment.

The throttling apparatus expands the liquid-phase refrigerant in a high-temperature and high-pressure state formed in the condenser into a low-temperature and low-pressure liquid-phase refrigerant. The liquid-phase refrigerant formed in the throttling apparatus is evaporated by the evaporator into low-temperature and low-pressure refrigerant gas which then returns to the compressor 161. The evaporator can achieve a refrigerating effect by heat exchange between evaporation latent heat of the refrigerant and a material to be refrigerated. In the present application, the evaporator exchanges heat with air to form air for cooling the storage compartment, so as to realize cooling of the storage compartment. The throttling apparatus may be a capillary tube.

A filter is also arranged downstream of the condenser. The filter is configured to filter impurities in the refrigerant, so as to improve a heat exchange efficiency of a refrigerating unit, and meanwhile lower the risk of pipeline blockage.

A liquid storage tank may also be arranged on a suction side of the compressor 161. The liquid storage tank is configured to perform gas-liquid separation on the refrigerant. The liquid storage tank is a shell-shaped component, and after the gas-liquid mixed refrigerant enters the liquid storage tank, the liquid refrigerant is deposited at the bottom of the tank under the action of gravity, and the gaseous refrigerant enters the compressor 161 from a gas outlet, so as to avoid that a service life of the compressor 161 is shortened due to the fact that the liquid refrigerant enters the compressor 161.

The compressor 161 and the condenser may be arranged at on rear lower side of the cabinet, and the evaporator may be arranged at a position of a rear side of the cabinet corresponding to the storage compartment. The evaporator and the condenser may also be arranged at other positions of the refrigerator body 10 as required, which are not further enumerated herein.

The refrigerator body 10 further includes a fan 162 (referring to FIG. 4). The fan 162 is configured to drive circulation of cold air inside the refrigerator to ensure even distribution of the cold air.

In one or more embodiments of the present application, the fan 162 includes a refrigerating fan. The refrigerating fan is arranged close to the evaporator of the refrigerating compartment and is configured to drive the cold air generated by the evaporator to flow to the refrigerating compartment and enable air in the refrigerating compartment to return to the evaporator to realize air circulation.

In one or more embodiments of the present application, the fan 162 includes a freezing fan arranged near the evaporator of the freezing compartment and configured to drive the cold air generated by the evaporator to flow to the freezing compartment and return air of the freezing compartment to the evaporator to realize air circulation.

In one or more embodiments of the present application, the fan 162 may also be arranged in cooperation with the condenser.

In one or more embodiments of the present application, the evaporator may also include a refrigerating compartment cooler and a freezing compartment cooler corresponding to the refrigerating compartment and the freezing compartment respectively.

A defrosting element is arranged in the refrigerator body 10 and configured to form heat for defrosting the evaporator to cause the evaporator to be in a defrosting state. In one or more embodiments of the present application, the defrosting element includes a defrosting heater 163 (referring to FIG. 4).

In some embodiments, the defrosting heater 163 may be an electric tracing band or an electric heater.

In some other embodiments, the defrosting element may also be a combination of an electric tracing band or an electric heater and a heat exchanger or a heat exchange pipeline. When a defrosting condition is met, the heat exchange pipeline is connected, the high-temperature and high-pressure refrigerant discharged by the compressor 161 enters the heat exchange pipeline to exchange heat with surrounding air to increase a temperature of the air, and heat for melting a frost layer on a surface of the evaporator is further provided to cause the evaporator to be in the defrosting state. The heat exchange pipeline may be arranged below the evaporator, and since a density of hot air at the heat exchange pipeline is less than that of surrounding cold air, the hot air rises to a position of the evaporator to remove ice or the frost layer on the evaporator.

In other embodiments, the defrosting element formed by the electric tracing band or the electric heater can also be arranged at other positions around the evaporator, for example, on an upper side or one side of the evaporator.

In some embodiments, a display 164 is arranged on the refrigerator body 10.

A hardware constitution of the processing apparatus 20 in some embodiments is shown schematically in FIG. 3. In some embodiments, the processing apparatus 20 includes a processor 201. The processor 201 may be a microprocessor, a dedicated processor, a central processing unit, or the like.

In some embodiments, the processing apparatus 20 further includes a storage medium such as a transitory memory 203 and/or a non-transitory memory 202. The storage medium includes a medium such as a CD-ROM, a floppy disk, or a magneto-optical disk which optically, electrically, or magnetically records information. The storage medium may also be a semiconductor memory such as an ROM, or a flash memory which electrically records information.

The storage medium has stored therein program instructions, and the processor 201 is configured to execute the program instructions stored in the storage medium to implement associated functions.

In some embodiments, the processing apparatus 20 further includes a display apparatus 204. The display apparatus 204 is configured to display various information.

In some embodiments, the processing apparatus 20 further includes an operating apparatus 205. The user performs operations such as inputting through the operating apparatus 205. For example, the operating apparatus 205 may be a touch screen, a button, a keyboard, a voice recognition apparatus, or the like.

In some embodiments, the processing apparatus 20 further includes a communication interface 206. The communication interface 206 is configured to communicate with other elements inside the refrigerator and/or external apparatuses.

In some embodiments, the processing apparatus 20 further includes a driving apparatus 207, and the driving apparatus 207 is a hardware terminal interacting with the storage medium.

In some embodiments, the processor 201, the transitory memory 203, the non-transitory memory 202, the display apparatus 204, the operating apparatus 205, the communication interface 206, and the driving apparatus 207 are connected to each other via a bus 208.

In one or more embodiments of the present application, the processing apparatus 20 may be a controller 13. The controller 13 is arranged in the refrigerator body 10.

In one or more embodiments of the present application, the processing apparatus 20 may be an apparatus independent of the controller 13 in the refrigerator body 10 and configured to be communicatively connected with the controller 13.

In one or more embodiments of the present application, the processing apparatus 20 may also be an electronic apparatus independent of the refrigerator and configured to be communicatively connected with the controller 13, for example, functions of the processing apparatus 20 are achieved by a terminal device 15 and/or a server 14. For example, the server 14 may be a cloud server.

In one or more embodiments of the present application, some functions of the processing apparatus 20 may be achieved by the controller 13, and some functions thereof may be achieved by the terminal device 15 and/or the server 14.

The controller 13 may communicate with the terminal device 15 and/or the server 14 via a network. The network between the controller 13 and the terminal device 15 or between the controller 13 and the server 14 may be the Internet, a cellular network, a Wi-Fi network, a low power wide area network based on standards and protocols such as LoRa, Sigfox, and NB-IoT, a wide area network, a local area network, etc.

The refrigerator 1 can be used in a home environment for storing daily necessities such as food and cold drink, can also be used in commercial places such as restaurants, hotels, supermarkets, and convenience stores for storing food materials, food and beverages to meet requirements of customers, and can also be used in places such as hospitals and laboratories for storing drugs and biological samples to meet requirements of medical treatment and scientific research.

The server 14 may provide various network services, for example, provide resource and data access for the controller 13 and the terminal device 15 of the refrigerator 1. The server 14 has higher performances and reliability. The server 14 can be connected with the controllers 13 of a plurality of refrigerators 1, a plurality of terminal devices 15 or other intelligent home appliance terminals.

The terminal device 15 may be communicatively connected with the server 14, the controller 13 and/or the processing apparatus 20 through a network, so as to achieve functions of remote control, data exchange, manmachine interaction, or the like. The terminal device 15 includes, but is not limited to, a smart phone, a tablet computer, a smart speaker, a wearable device, a smart appliance (e.g., a smart television), a smart vehicle-mounted device, or the like. A manner of an interaction between the terminal device 15 and the user includes, but is not limited to, an operation on a screen by a finger or a touch pen, various operations by keys, voice control, gesture control, iris recognition, face recognition, or the like.

Referring to FIG. 4, in one or more embodiments of the present application, the controller 13 is communicatively connected with a sensor assembly 30. The controller 13 acquires data sensed by the sensor assembly 30 and sends the data to the processing apparatus 20. In some other embodiments, the processing apparatus 20 may be communicatively connected with the sensor assembly 30 to obtain the data sensed by the sensor assembly.

The sensor assembly 30 includes a variety of sensors, and at least some of the sensors are arranged in the refrigerator body 10.

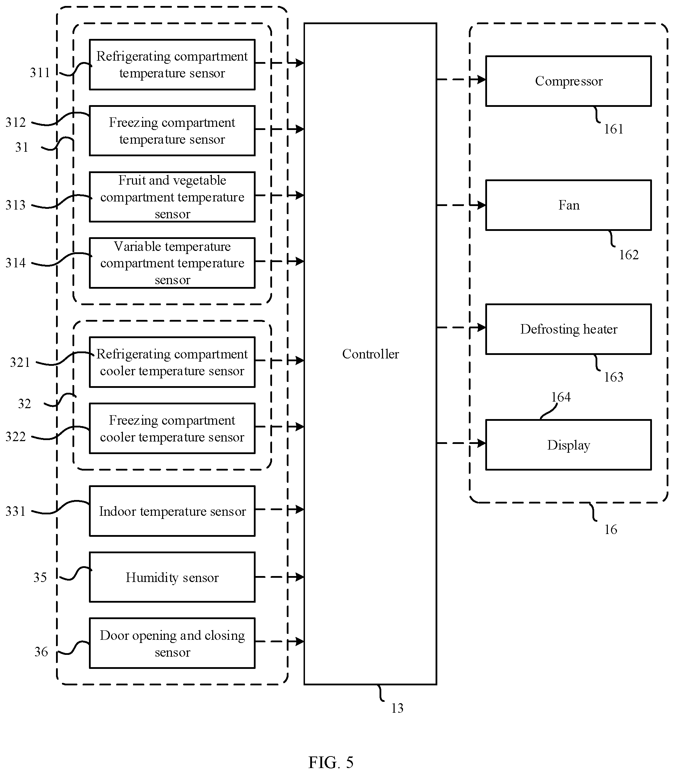

As shown in FIG. 4 and FIG. 5, in one or more embodiments of the present application, the sensor assembly 30 includes a compartment temperature sensor 31. Exemplarily, the compartment temperature sensor 31 includes one or more of a refrigerating compartment temperature sensor 311, a freezing compartment temperature sensor 312, a fruit and vegetable compartment sensor 313, and a variable temperature compartment temperature sensor 314.

In one or more embodiments of the present application, the sensor assembly 30 includes an evaporator temperature sensor 32 configured to detect a temperature of the evaporator. Exemplarily, the evaporator temperature sensor 32 includes one or more of a refrigerating compartment evaporator temperature sensor 321 and a freezing compartment evaporator temperature sensor 322.

In one or more embodiments of the present application, the sensor assembly 30 includes an environment temperature sensor 33. The environment temperature sensor 33 is configured to sense a temperature of the environment around the refrigerator 1. For example, the environment temperature sensor 33 includes at least one of an indoor temperature sensor 331 and an outdoor temperature sensor (not shown in the drawing).

In some other embodiments, an outdoor temperature may be obtained by querying the server.

In one or more embodiments of the present application, the sensor assembly 30 further includes an electrical parameter sensor 34. A number of the electrical parameter sensors 34 is not limited, and the electrical parameter sensors 34 may be configured to detect one or more of an electric quantity, a peak electric quantity, a valley electric quantity, a current, a voltage, and an energy efficiency.

In one or more embodiments of the present application, the sensor assembly 30 further includes a rotation speed sensor (not shown in the drawing). The rotation speed sensor is configured to detect a rotation speed of the compressor, a rotation speed of the fan, or the like.

In one or more embodiments of the present application, the sensor assembly 30 may further include other sensors such as a humidity sensor, a door opening and closing sensor, a vibration sensor, and a weight sensor, which is not particularly limited in the present application.

In one or more embodiments of the present application, the refrigerator body 10 further includes a functional component 16 that operates based on electric power driving. The functional components 16 include, but are not limited to, the compressor 161, the fan 162, the defrosting heater 163, the display 164, a water pump in an ice making module, a motor in an ice crushing module, etc. In the embodiment of the present application, the refrigerator body 10 includes at least two functional components.

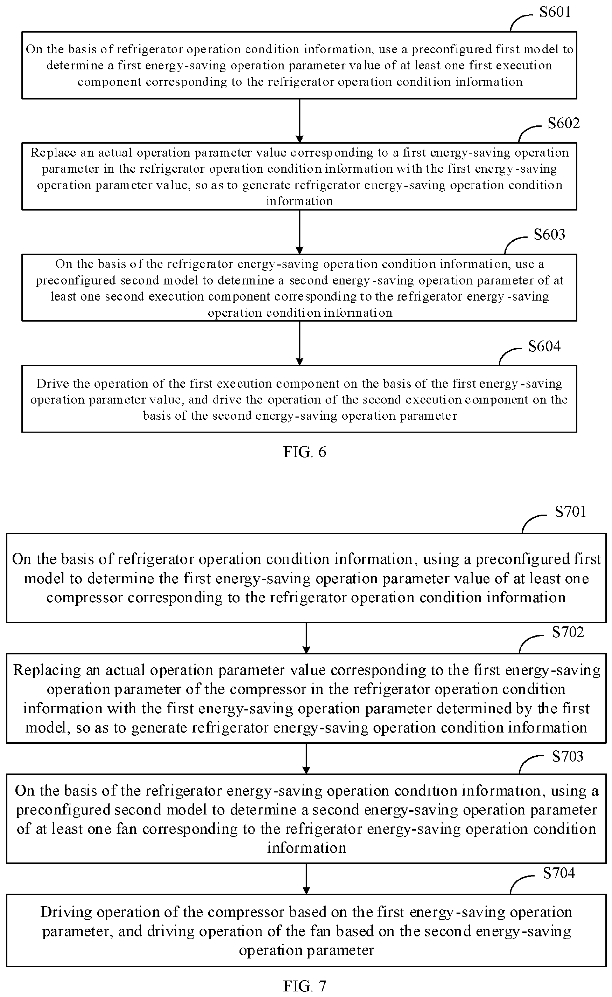

FIG. 6 shows a flowchart of a refrigerator control method performed by the processing apparatus 20 in some embodiments. The method includes steps S601 to S604.

Step S601: on the basis of refrigerator operation condition information, using, by the processing apparatus 20, a preconfigured first model (also called a main training model) to determine a value of a first energy-saving operation parameter (also called a main energy-saving operation parameter) of at least one first functional component 16 corresponding to the refrigerator operation condition information.

The refrigerator operation condition information refers to various information about an operation state of the refrigerator body 10 displayed or transmitted in a working state thereof, and represents a working condition of the refrigerator body 10. The refrigerator operation condition information may include parameters detected by the various sensors in the sensor assembly 30 and working state parameters of the functional component 16. For example, the refrigerator operation condition information includes a refrigerating compartment temperature, a freezing compartment temperature, the rotation speed of the compressor 161, the rotation speed of the fan, a state of the defrosting heater 163, and a working state of the compressor. The refrigerator operation condition information may further include working mode information (including an energy saving mode, a holiday mode, etc.), a door opening and closing state, a function state (e.g., a network connection state, and a software update state), a power consumption state, etc.

In some embodiments, the processing apparatus 20 sends an inquiry instruction to the controller 13 or the sensor assembly 30 at a preset time interval, and the controller 13 or the sensor assembly 30 uploads the refrigerator operation condition information to the processing apparatus 20 in response to the inquiry instruction. In some other embodiments, the sensor assembly 30 may actively upload the refrigerator operation condition information to the processing apparatus 20. For example, the sensor assembly 30 actively sends the refrigerator operation condition information to the processing apparatus 20 at a preset time interval.

The first model (i.e., the main training model) is a model capable of determining the first energy-saving operation parameter value of the first functional component according to the refrigerator operation condition information, and energy-saving operation condition information of the refrigerator can be generated according to the first energy-saving operation parameter output by the first model, and is used as an input of other models configured to determine energy-saving operation parameters of other functional components.

It should be noted that the first energy-saving operation parameter is an optimized operation parameter value output by the first model, and when the first functional component operates according to the optimized operation parameter value, an energy-saving effect of the refrigerator can be improved.

In one or more embodiments of the present application, the first functional component is a functional component with a highest energy consumption in the refrigerator body 10. In some embodiments, the first functional component is the compressor.

In one or more embodiments of the present application, the main energy-saving operation parameter is an operation parameter of the functional component 16 with the highest energy consumption in the refrigerator body 10, for example, an operation parameter of the compressor 161, including but not limited to one or more of a frequency (rotation speed), a current, a voltage, an electric power, or a current waveform and feature of the compressor 161.

In one or more embodiments of the present application, the main training model may be a machine learning model or a deep learning model such as a linear regression model, a decision tree, a random forest and a neural network model. A configuration process of the main training model includes the steps of data collection, data cleaning, modeling, training, evaluation, tuning, deployment, or the like. A training process of the main training model may be the prior art, and is not repeated herein. An input feature of the main training model is the operation condition information of the refrigerator, and an output feature thereof is the main energy-saving operation parameter value.

In one or more embodiments of the present application, the main training model may be a reinforcement learning model. Reinforcement learning is performed by changing at least one of, for example, the operation frequency (speed) of the compressor and the working state of the compressor as an action to obtain the main energy-saving operation parameter.

A process for constructing the reinforcement learning model is briefly described below, in which the parameters from the sensor assembly 30 in the refrigerator operation condition information are used as a state space, such as the refrigerating compartment temperature, the freezing compartment temperature, a humidity, and the door opening and closing state; an operation of the functional component 16 is used as an action space, such as the operation frequency of the compressor, the rotation speed of the fan or a working duration of the defrosting heater. A reward function of the main training model is designed to measure effectiveness of each action.

Exemplarily, the reward function R may be designed as:
$R = {R}_{B} - a ∗ P + b ∗ {R}_{s} + c ∗ {R}_{U}$
wherein R_{B} is a fixed basic reward under the condition of keeping a proper temperature and humidity, P is a penalty value generated according to a current electricity consumption condition, and the higher the electricity consumption is, the higher the penalty value is; Rₛ is a reward value given for each action, and the action is, for example, adjustment of the operation frequency of the compressor, the rotation speed of the fan, or the like; R_{U} is a reward value given according to the energy efficiency, and a, b and c are parameters, and can be adjusted and optimized according to specific conditions, so as to ensure that the reward function can encourage an energy-saving behavior and operation.

In one or more embodiments of the present application, the reward function R may also be other forms of empirical formulas.

In some embodiments, a corresponding reinforcement learning algorithm is selected and an environment simulator is established to simulate an operation environment of the refrigerator body 10. The reinforcement learning algorithm may be Q-learning, a deep Q network, a policy gradient, etc. The environment simulator is configured to automatically predict a corresponding reward of the next state according to the current state and action, and the environment simulator can be constructed by adopting a temporal difference method, a recurrent neural network, a convolutional neural network, or the like. The model is trained through the environment simulator to cause the model to learn a manner of selecting an optimal action to maximize an accumulated reward according to the current state. The model is evaluated and tested to verify a performance of the model in a real environment, and the model is taken as the main training model for determining the main energy-saving operation parameter when the performance of the model reaches a preset standard.

Step S602: replacing, by the processing apparatus, a value of an actual operation parameter corresponding to the first energy-saving operation parameter in the refrigerator operation condition information with the value of the first energy-saving operation parameter determined by the first model, so as to generate the refrigerator energy-saving operation condition information.

Exemplarily, if the operation frequency of the compressor is used as the main energy-saving operation parameter, the actual operation frequency of the compressor in the refrigerator operation condition information corresponding to the main energy-saving operation parameter is replaced with the value of the operation frequency of the compressor determined by the first model, so as to obtain the refrigerator energy-saving operation condition information. Therefore, the refrigerator energy-saving operation condition information is the optimized energy-saving operation parameter determined by the first model, and can reflect the current energy-saving operation state.

Step S603: on the basis of the refrigerator energy-saving operation condition information, using, by the processing apparatus 20, a preconfigured second model (also called an additional training model) to determine a value of a second energy-saving operation parameter (also called an auxiliary energy-saving operation parameter) of at least one second functional component corresponding to the refrigerator energy-saving operation condition information.

In one or more embodiments of the present application, the second functional component is different from the first functional component. The auxiliary energy-saving operation parameter is an operation parameter of other functional components 16 in the refrigerator body 10 different from the first functional component. For example, when the first functional component is the compressor and the main energy-saving operation parameter is the operation parameter of the compressor, the auxiliary energy-saving operation parameter is the operation parameter of the fan 162 or the operation parameter of the defrosting heater 163, including but not limited to the rotation speed of the fan, an operation time of the defrosting heater, a power of the defrosting heater, or the like.

The second model (i.e., the additional training model) refers to a model that outputs the operation parameter of the second functional component, and an input value of the second model includes the operation condition information of the first energy-saving operation parameter generated by the first model. The second model outputs an optimized operation parameter value, and when the second functional component operates according to the optimized operation parameter value, the energy-saving effect of the refrigerator can be improved.

In one or more embodiments of the present application, the additional training model may be a machine learning or deep learning model such as a linear regression model, a decision tree, a random forest and a neural network model. A configuration process of the additional training model includes the steps of data collection, data cleaning, modeling, training, evaluation, tuning, deployment, or the like. A training process of the additional training model may be the prior art, and is not repeated herein. An input feature of the additional training model is the refrigerator energy-saving operation condition information, and an output feature thereof is the auxiliary energy-saving operation parameter.

In one or more embodiments of the present application, the additional training model may also be a reinforcement learning model.

In some embodiments of the present application, the processing apparatus 20 decomposes and processes an energy-saving task using at least two models, the main training model is configured to determine the main energy-saving operation parameter value, and the additional training model is configured to determine the auxiliary energy-saving operation parameter value. By means of the decomposition, the main training model and the additional training model can be focused on specific tasks, a learning prediction capability of each model is improved, and features of and a relationship between the operation condition of the refrigerator body 10 and the functional component 16 with the highest energy consumption under an energy-saving dimension are obtained through the main training model, so that the refrigerator energy-saving operation condition information is obtained, and parameters of the functional component with the highest energy consumption are fixed. Under the condition of relative energy saving, the features of and the relationships between the refrigerator operation condition and other functional components under the energy-saving dimension are further obtained, and a deduction capability of the additional training model is improved. The energy-saving setting task is decoupled and modularized through the main training model and the additional training model, and meanwhile, a system is more flexible and extensible, a complex energy-saving optimization task can be better dealt with, and an energy-saving effect is improved.

Step S604: by the processing apparatus 20, controlling operation of the first functional component according to the first energy-saving operation parameter value, and controlling operation of the second functional component according to the second energy-saving operation parameter value.

In some embodiments, the first model and the second model are both deployed in the processing apparatus of the refrigerator, that is, the first model and the second model are both deployed in the refrigerator, and in this case, the processing apparatus performs the steps as shown in S601-S604.

In some other embodiments, the first model and the second model are both deployed in the server 14. In this case, the processing apparatus 20 (which may also be the controller 13) in the refrigerator sends the refrigerator operation condition information to the server 14. For example, the server 14 may send an acquisition instruction to the refrigerator, and the refrigerator sends the operation condition information to the server in response to the acquisition instruction. Alternatively, the refrigerator actively sends the operation condition information to the server.

After receiving the refrigerator operation condition information, the server 14 performs the following operations: on the basis of the refrigerator operation condition information, using the first model to determine the value of the first energy-saving operation parameter of at least one first functional component corresponding to the refrigerator operation condition information; replacing the value of the actual operation parameter corresponding to the first energy-saving operation parameter in the refrigerator operation condition information with the value of the first energy-saving operation parameter determined by the first model, so as to generate the refrigerator energy-saving operation condition information; on the basis of the refrigerator energy-saving operation condition information, using the second model to determine the value of the second energy-saving operation parameter of at least one second functional component corresponding to the refrigerator energy-saving operation condition information; and sending the first energy-saving operation parameter and the second energy-saving operation parameter to the processing apparatus 20 (control apparatus 13) of the refrigerator. The processing apparatus 20 (controller 13) in the refrigerator controls the operation of the first functional component according to the received first energy-saving operation parameter, and controls the operation of the second functional component according to the received second energy-saving operation parameter.

The deployment of the first model and the second model in the server can lower requirements of a refrigerator side for a storage space and computing power, and reduce the cost of the refrigerator on the premise of realizing effective energy saving.

It is understood that, in other embodiments, when the home appliance is other devices than the refrigerator, the operation condition information is operation condition information of the corresponding device. For example, when the home appliance is an air conditioner, the operation condition information is operation condition information of the air conditioner, and the functional component is a functional component of the air conditioner.

The technical solution of the present application is further explained below with reference to several specific application scenarios.

FIG. 7 is a flowchart of a refrigerator control method performed by the processing apparatus 20 in an embodiment. In one or more embodiments of the present application, the functional components 16 include the compressor 161 and the fan 162. The compressor 161 is the first functional component, and the fan 162 is the second functional component. The refrigerator control method performed by the processing apparatus 20 includes the following steps.

Step S701: on the basis of refrigerator operation condition information, using, by the processing apparatus 20, a preconfigured first model to determine an operation parameter value (i.e., the first energy-saving operation parameter value) of at least one compressor corresponding to the refrigerator operation condition information.

Exemplarily, the refrigerator operation condition information includes a refrigerating compartment temperature, a freezing compartment temperature, the rotation speed of the compressor, the rotation speed of the fan, a state of the defrosting heater, and a working state of the compressor. After the refrigerator operation condition information is input into the first model, the first model outputs the first energy-saving operation parameter value as a compressor rotation speed value.

It can be understood that the rotation speed of the compressor in the refrigerator operation condition information is a compressor actual rotation speed value in a refrigerator operation process, and the compressor rotation speed value in the first energy-saving parameter value is the compressor rotation speed value calculated by the first model.

Step S702: replacing, by the processing apparatus 20, an actual operation parameter value corresponding to the operation parameter value of the compressor in the refrigerator operation condition information with the first energy-saving operation parameter value determined by the first model, so as to generate refrigerator energy-saving operation condition information.

Continuing with the previous example, the compressor actual rotation speed value in the refrigerator operation condition information is replaced with the compressor rotation speed value output by the first model (i.e., a first energy-saving operation parameter value), so as to obtain the refrigerator energy-saving operation condition information.

Step S703: on the basis of the refrigerator energy-saving operation condition information, using, by the processing apparatus 20, a preconfigured second model to determine an operation parameter value (i.e., a second energy-saving operation parameter) of at least one fan 162 corresponding to the refrigerator energy-saving operation condition information.

Continuing with the previous example, after the refrigerator energy-saving operation condition information is input to the second model, the second model outputs the second energy-saving operation parameter of the fan as the rotation speed of the fan.

Step S704: by the processing apparatus 20, driving operation of the compressor 161 based on the first energy-saving operation parameter value, and driving operation of the fan 162 based on the second energy-saving operation parameter value.

Continuing with the previous example, the processing apparatus 20 drives the operation of the compressor based on the compressor rotation speed value output by the first model and drives the operation of the fan based on a fan rotation speed value output by the second model.

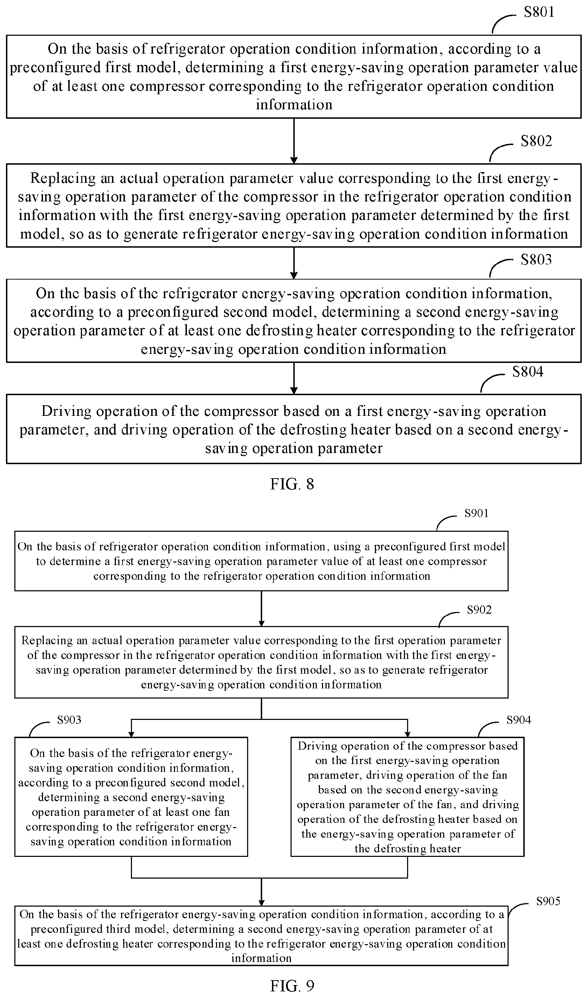

FIG. 8 is a flowchart of a refrigerator control method performed by the processing apparatus 20 in an embodiment. In one or more embodiments of the present application, the functional components 16 include the compressor 161 and the defrosting heater 163. The compressor 161 is the first functional component, and the defrosting heater is the second functional component.

S801: on the basis of refrigerator operation condition information, using, by the processing apparatus 20, a preconfigured first model to determine a first energy-saving operation parameter of at least one compressor corresponding to the refrigerator operation condition information.

Exemplarily, the refrigerator operation condition information includes a refrigerating compartment temperature, a freezing compartment temperature, the rotation speed of the compressor, the rotation speed of the fan, a state of the defrosting heater, and a working state of the compressor. After the refrigerator operation condition information is input into the first model, the first model outputs the first energy-saving operation parameter value as a compressor rotation speed value.

It can be understood that the rotation speed of the compressor in the refrigerator operation condition information is a compressor actual rotation speed value in a refrigerator operation process, and the compressor rotation speed value in the first energy-saving parameter value is the compressor rotation speed value calculated by the first model.

S802: replacing, by the processing apparatus 20, an actual operation parameter value corresponding to the first energy-saving operation parameter of the compressor in the refrigerator operation condition information with the first energy-saving operation parameter determined by the first model, so as to generate refrigerator energy-saving operation condition information.

Continuing with the previous example, the compressor actual rotation speed value in the refrigerator operation condition information is replaced with the compressor rotation speed value output by the first model (i.e., a first energy-saving operation parameter value), so as to obtain the refrigerator energy-saving operation condition information.

S803: on the basis of the refrigerator energy-saving operation condition information, using, by the processing apparatus 20, a preconfigured second model to determine a second energy-saving operation parameter of at least one defrosting heater 163 corresponding to the refrigerator energy-saving operation condition information.

Exemplarily, after the refrigerator energy-saving operation condition information is input to the second model, the second energy-saving operation parameter of the defrosting heater 163 output by the second model is a ratio between a power-on time and a power-off time of the defrosting heater.

S804: by the processing apparatus 20, driving operation of the compressor 161 based on a first energy-saving operation parameter value, and driving operation of the defrosting heater 163 based on a second energy-saving operation parameter value.

FIG. 9 is a flowchart of a refrigerator control method performed by the processing apparatus 20 in an embodiment. In one or more embodiments of the present application, the functional components 16 include the compressor 161, the fan 162 and the defrosting heater 163.

S901: on the basis of refrigerator operation condition information, using, by the processing apparatus 20, a preconfigured first model to determine a first energy-saving operation parameter of at least one compressor corresponding to the refrigerator operation condition information.

S902: replacing, by the processing apparatus 20, an actual operation parameter corresponding to the first energy-saving operation parameter of the compressor in the refrigerator operation condition information with the first energy-saving operation parameter determined by the first model, so as to generate refrigerator energy-saving operation condition information.

S903: on the basis of the refrigerator energy-saving operation condition information, using, by the processing apparatus 20, a preconfigured second model (also called a first additional training model) to determine a second energy-saving operation parameter (i.e., an auxiliary energy-saving operation parameter) of at least one fan 162 corresponding to the refrigerator energy-saving operation condition information.

S904: on the basis of the refrigerator energy-saving operation condition information, using a preconfigured third model (also called a second additional training model) to determine a second energy-saving operation parameter (i.e., an auxiliary energy-saving operation parameter) of at least one defrosting heater 163 corresponding to the refrigerator energy-saving operation condition information.

S905: driving operation of the compressor 161 based on the first energy-saving operation parameter, driving operation of the fan 162 based on the second energy-saving operation parameter of the fan, and driving operation of the defrosting heater 163 based on the second energy-saving operation parameter of the defrosting heater.

It may be understood that the order of the steps S903 and S904 may be exchanged or performed simultaneously, and the execution order is not limited in the present application.

In one or more embodiments of the present application, the first additional training model M2 and the second additional training model M3 may be two separate models.

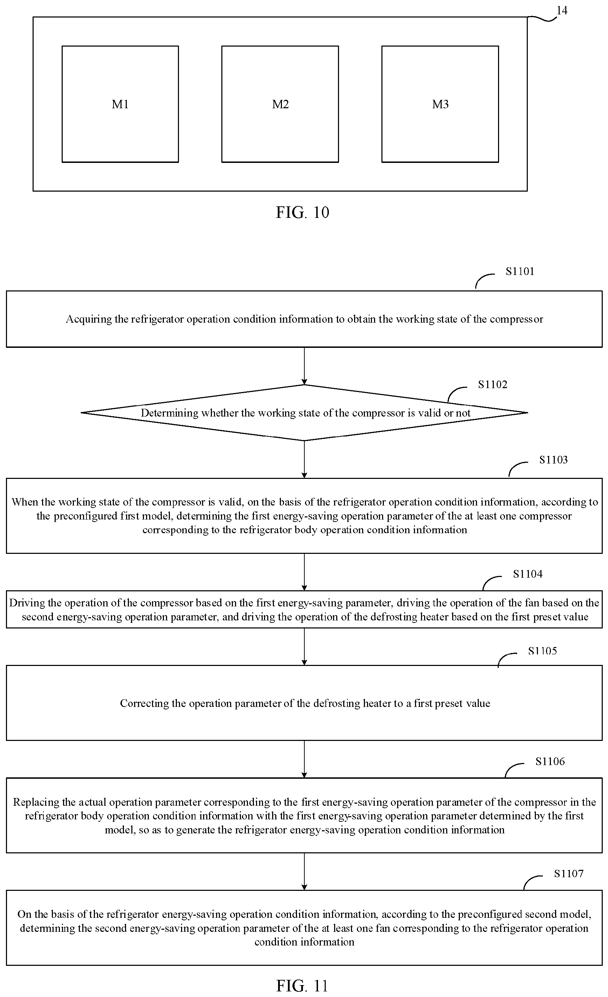

Exemplarily, the main training model M1, the first additional training model M2, and the second additional training model M3 are preconfigured in the server 14, as shown in FIG. 10. Exemplarily, the refrigerator operation condition information Xt may be input into the main training model M1, the operation rotation speed Sc of the compressor 161 is determined by the main training model M1, the actual operation rotation speed of the compressor 161 in Xt is replaced with Sc to obtain the refrigerator energy-saving operation condition information Xt', and Xt' is input into the first additional training model M2 and the second additional training model M3 respectively to obtain the operation parameter of the fan 162 and the operation parameter of the defrosting heater. The operation parameter of the fan 162 may be the rotation speed Sf of the fan, and the operation parameter of the defrosting heater may be a defrosting heating coefficient h.

The defrosting heating coefficient represents a working state time ratio of the defrosting heater 163 in a set period, i.e., the ratio of the power-on time and the power-off time of the defrosting heater 163 in the set period. For example, the set period is T, and during defrosting, the defrosting heater 163 first works for h×T minutes, and then is powered off for (1-h)×T minutes, h being less than 1. The process is repeated until defrosting operation is exited.

In some embodiments, as shown in FIG. 11, the processing apparatus 20 is further configured to perform the following steps.

S1101: acquiring, by the processing apparatus 20, the refrigerator operation condition information to obtain the working state of the compressor 161.

S1102: determining whether the working state of the compressor is valid or not.

S1103: when the working state of the compressor is valid, on the basis of the refrigerator operation condition information, using the preconfigured first model to determine the first energy-saving operation parameter (also called a main energy-saving operation parameter) of the at least one compressor corresponding to the refrigerator operation condition information.

S1104: correcting the operation parameter of the defrosting heater to a first preset value.

In some embodiments, correcting the operation parameter of the defrosting heater to the first preset value includes setting a defrosting coefficient of the defrosting heater to 0.

S1105: replacing the actual operation parameter corresponding to the first energy-saving operation parameter of the compressor in the refrigerator operation condition information with the first energy-saving operation parameter determined by the first model, so as to generate the refrigerator energy-saving operation condition information.

S1106: on the basis of the refrigerator energy-saving operation condition information, using the preconfigured second model (i.e., the first additional training model) to determine the second energy-saving operation parameter of the at least one fan 162 corresponding to the refrigerator operation condition information.

S1107: driving the operation of the compressor 161 based on the first energy-saving parameter, driving the operation of the fan 162 based on the second energy-saving operation parameter, and driving the operation of the defrosting heater 163 based on the first preset value.

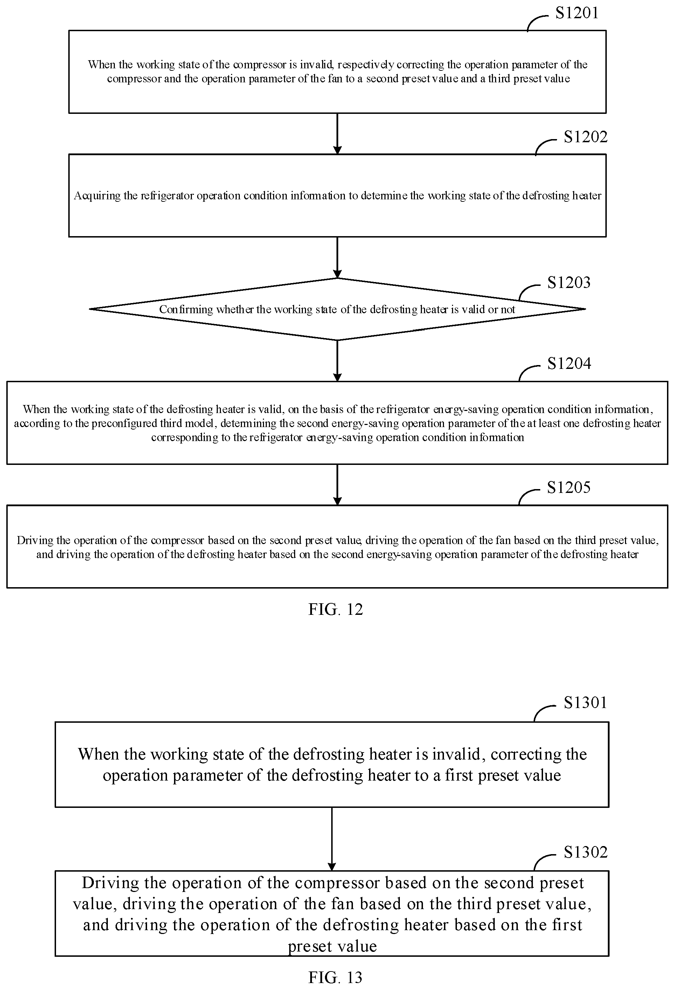

In an embodiment, as shown in FIG. 12, the processing apparatus is further configured to perform the following steps.

S1201: when the working state of the compressor is invalid, respectively correcting the operation parameter of the compressor and the operation parameter of the fan 162 to a second preset value and a third preset value.

S1202: acquiring the refrigerator operation condition information to determine the working state of the defrosting heater 163.

S1203: confirming whether the working state of the defrosting heater 163 is valid or not.

S1204: when the working state of the defrosting heater 163 is valid, on the basis of the refrigerator energy-saving operation condition information, according to the preconfigured third model (i.e., the second additional training model), determining the second energy-saving operation parameter (i.e., the auxiliary energy-saving operation parameter) of the at least one defrosting heater corresponding to the refrigerator energy-saving operation condition information.

S1205: driving the operation of the compressor 161 based on the second preset value, driving the operation of the fan 162 based on the third preset value, and driving the operation of the defrosting heater 163 based on the second energy-saving operation parameter of the defrosting heater.

As shown in FIG. 13, in one or more embodiments of the present application, the processing apparatus is further configured to perform the following steps.

S1301: when the working state of the defrosting heater 163 is invalid, correcting the operation parameter of the defrosting heater to a first preset value.

S1302: driving the operation of the compressor 161 based on the second preset value, driving the operation of the fan 162 based on the third preset value, and driving the operation of the defrosting heater 163 based on the first preset value.

In one or more embodiments of the present application, the operation parameter of the defrosting heater corresponding to the refrigerator energy-saving operation condition information includes the defrosting heating coefficient; the defrosting heating coefficient represents the working state time ratio of the defrosting heater 163 within the set period.

The defrosting heating coefficient represents the working state time ratio of the defrosting heater 163 in the set period, i.e., the ratio of the power-on time and the power-off time of the defrosting heater 163 in the set period. For example, the set period is T, and during defrosting, the defrosting heater 163 first works for h×T minutes, and then is powered off for (1-h)×T minutes. The process is repeated until defrosting operation is exited.

In one or more embodiments of the present application, the first preset value may be the defrosting heating coefficient h of 0.

In one or more embodiments of the present application, the second preset value may be the rotation speed of the compressor 161 of 0.

In one or more embodiments of the present application, the third preset value may be the rotation speed of the fan of 0.

Exemplarily, the main training model M1, the first additional training model M2, and the second additional training model M3 are preconfigured in the server 14.

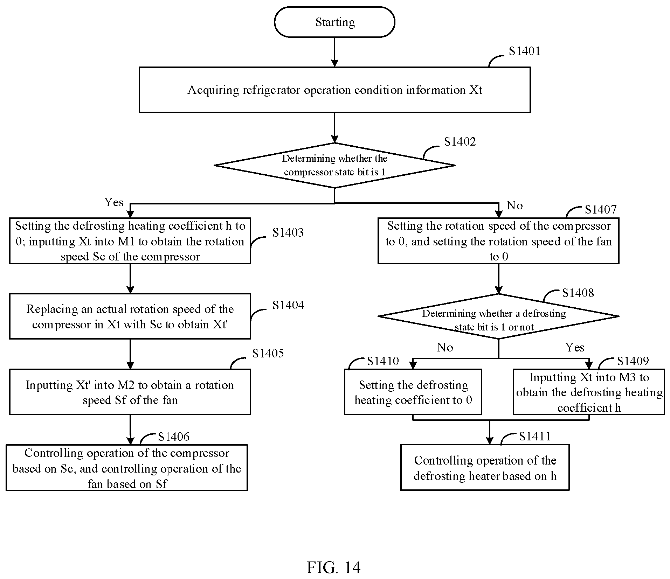

As shown in FIG. 14 which is a flowchart of an exemplary refrigerator control method, and the control method includes the following steps.

S1401: first acquiring refrigerator operation condition information Xt, for example, one or more frames of communication data.

S1402: reading a working state of the compressor in the refrigerator operation condition information Xt, for example, reading data corresponding to a compressor 161 state bit therein, and determining whether the compressor state bit is 1. For example, when the compressor 161 state bit is 1, the compressor 161 is in the working state; when the compressor 161 state bit is 0, the compressor 161 is in a non-working state.

S1403: when the compressor 161 state bit is 1, confirming that the working state of the compressor is valid, inputting the refrigerator operation condition information Xt into a main training model M1 to obtain an operation rotation speed Sc of the compressor 161, and correcting an operation parameter of the defrosting heater to a first preset value, for example, setting a defrosting heating coefficient h to 0. Step S1404 is then executed.

S1404: replacing an actual operation rotation speed of the compressor 161 in Xt with Sc to obtain refrigerator energy-saving operation condition information Xt'.

S1405: inputting Xt' into a first additional training model M2 to obtain a rotation speed Sf of the fan.

S1406: controlling the compressor 161 based on Sc, and controlling the fan based on Sf.

S1407: when the compressor 161 state bit is 0, confirming that the working state of the compressor is invalid and the compressor 161 is in a shutdown state, correcting an operation parameter of the compressor and an operation parameter of the fan 162 to a second preset value and a third preset value respectively, for example, setting the rotation speed of the compressor 161 to 0 and setting the rotation speed of the fan to 0. Step S1408 is then executed.

S1408: acquiring the refrigerator operation condition information Xt, and reading a working state of the defrosting heater 163 in Xt, for example, reading data corresponding to a defrosting state bit, wherein for example, when the defrosting state bit is 1, the defrosting heater 163 is in the working state; when the defrosting state bit is 0, the defrosting heater 163 is in a non-working state.

S1409: when the defrosting heater 163 is in the working state, that is, when the defrosting state bit is 1, inputting the refrigerator energy-saving operation condition information Xt into a preconfigured second additional training model M3, so as to determine the operation parameter of the defrosting heater corresponding to the operation condition information of the refrigerator body 10, for example, the coefficient h of the defrosting heater 163, as an auxiliary operation parameter. Step S1411 is then executed.

S1410: setting the defrosting heating coefficient h to 0 when the defrosting state bit is 0. Step S1411 is then executed.

S1411: controlling the defrosting heater 163 based on the coefficient h of the defrosting heater 163.

The processing apparatus 20 in the refrigerator 1 according to this embodiment determines the performed operation by confirming the working state of the compressor, and corrects the operation parameter of the compressor and the operation parameter of the fan 162 to the second preset value and the third preset value when the working state of the compressor is invalid, thereby saving computing power and increasing a response speed while ensuring a control effect, and better optimizing energy efficiency performance of the refrigerator 1. When the working state of the compressor is invalid, but the working state of the defrosting heater 163 is valid, the energy consumption of the defrosting heater 163 is further optimized, and the system can be ensured to be adjusted at any time in a dynamic environment to adapt to different working states, thus further optimizing a defrosting effect and the energy-saving effect, and improving an overall performance and efficiency of the system.

In some other embodiments, the first functional component may not be the functional component with the highest energy consumption. For example, the first functional component may be the fan or the defrosting heater and the second functional component may be the compressor. The first model is also not limited to determining the first energy-saving operation parameter of the most energy-efficient functional component. For example, the first model may also be configured to determine the first energy-saving operation parameter of the fan according to the refrigerator operation condition information. An actual fan operation parameter in the refrigerator operation condition information is replaced by the first energy-saving operation parameter of the fan output by the first model to obtain the energy-saving operation condition information. The second model determines the second energy-saving operation parameter of the compressor according to the energy-saving operation condition information.

In the foregoing solution, the input data of the second model involves the data output by the first model, and therefore, during training of the first model and the second model, the first model is trained first, and then, the second model is trained. In order to further save a model training time, some embodiments of the present application also provide a refrigerator, in which refrigerator operation condition information is respectively input to a plurality of preconfigured models, energy-saving operation parameters of a plurality of functional components are respectively determined by the plurality of models, and then, operation of each functional component is controlled according to the energy-saving operation parameter corresponding to the corresponding functional component. Therefore, the plurality of models can be trained simultaneously, the model training time is saved, and an efficiency is improved.

In some embodiments, the refrigerator includes a plurality of functional components and a processing apparatus 20, wherein the processing apparatus 20 is configured to:
acquire the refrigerator operation condition information, and respectively input the refrigerator operation condition information into at least two models, wherein the at least two models are configured to respectively determine energy-saving operation parameters of at least two functional components based on the refrigerator operation condition information, and different models determine the energy-saving operation parameters of different functional components; and
respectively control operation of the corresponding functional components according to the energy-saving operation parameters of the at least two functional components.

For the refrigerator operation condition information and the training method for the model, reference can be made to the previous embodiment, which are not repeated herein.

In an example, the functional components include the compressor and the fan, and the at least two preconfigured models include a first model and a second model, wherein the first model is configured to determine the energy-saving operation parameter of the compressor such as the rotation speed of the compressor according to the refrigerator operation condition information, and the second model is configured to determine the energy-saving operation parameter of the fan such as the rotation speed of the fan according to the refrigerator operation condition information. The processing apparatus is configured to:
acquire the refrigerator operation condition information;
respectively input the refrigerator operation condition information into the first model and the second model, so as to determine the energy-saving operation parameter of the compressor through the first model and determine the energy-saving operation parameter of the fan through the second model; and
control the operation of the compressor according to the energy-saving operation parameter of the compressor, and control the operation of the fan according to the energy-saving operation parameter of the fan.

In another example, the functional components include the compressor, the fan, and the defrosting heater, and the at least two preset models include a first model, a second model, and a third model. The first model is configured to determine the energy-saving operation parameter of the compressor such as the rotation speed of the compressor according to the refrigerator operation condition information. The second model is configured to determine the energy-saving operation parameter of the fan such as the rotation speed of the fan according to the refrigerator operation condition information. The third model is configured to determine the energy-saving operation parameter of the defrosting heater such as the defrosting coefficient of the defrosting heater according to the refrigerator operation condition information. The processing apparatus is configured to:
acquire the refrigerator operation condition information;
respectively input the refrigerator operation condition information into the first model, the second model and the third model, so as to determine the energy-saving operation parameter of the compressor through the first model, determine the energy-saving operation parameter of the fan through the second model, and determine the energy-saving operation parameter of the defrosting heater through the third model; and
control the operation of the compressor according to the energy-saving operation parameter of the compressor, control the operation of the fan according to the energy-saving operation parameter of the fan, and control the operation of the defrosting heater according to the energy-saving operation parameter of the defrosting heater.

In addition to the energy-saving design of the refrigerator, a power consumption of the refrigerator is displayed to the user, so that the user can know the power consumption in time and adjust a use habit of the refrigerator in time, which is also an effective means for saving the energy consumption. However, since the actual power consumption of the home appliance is greatly different from the power consumption under a standard working condition, the actual power consumption of the home appliance needs to be monitored and displayed to the user, so that the user can know the actual power consumption and adjust the use habit of the home appliance in time, so as to reduce the energy consumption.

In the related art, a power consumption monitoring model is deployed in the home appliance, and the monitoring model is used to replace an electricity metering module mounted on the refrigerator to calculate the power consumption. However, since the monitoring model has high requirements for a storage space and computing power, hardware resources of most home appliances cannot meet the requirements.

In some other implementations, the monitoring model can be deployed on a cloud server, the operation parameters are reported to the cloud server by using a networking function of the home appliance, and the cloud server inputs the received operation parameters into the monitoring model to output the power consumption.

However, if the home appliance is disconnected from a network within a certain time period, the home appliance cannot upload operation data within the network disconnection period to the cloud server, and data loss is caused, so that the calculated actual power consumption of the home appliance may have a large deviation.

Therefore, the present application further provides a power consumption monitoring method of a home appliance, in which if the home appliance is disconnected from the network in a current monitoring period, a plurality of first historical power consumptions can be input into a fourth model, so that the fourth model outputs a first power consumption in the current monitoring period. The solves the problem that the calculated actual power consumption is inaccurate due to the loss of the operation parameter during the network disconnection of the home appliance.

The power consumption monitoring method of a home appliance according to the embodiment of the present application can be applied to an application scenario shown in FIG. 2, and referring to FIG. 2, the scenario includes: a server 14, the home appliance 1, and a terminal device 15.

The server 14 may be a cloud server or a server cluster. The following description is given by taking the server 14 as a cloud server as an example.

The cloud server 14, the home appliance 1 and the terminal device 15 can communicate with each other through the Internet, and during operation of the home appliance 1, the cloud server 14 can monitor the power consumption of the home appliance 1 in each monitoring period, and send electricity information to the home appliance 1 or the terminal device 15 of the user, so that the user can conveniently check the actual power consumption of the home appliance.

The fourth model is deployed in the cloud server 14, and the cloud server 14 stores the plurality of first historical power consumptions of the home appliance 1. If the home appliance 1 is disconnected from the network in the current monitoring period, the cloud server may determine the power consumption of the home appliance 1 in the current monitoring period according to the plurality of first historical power consumptions and the fourth model deployed on the cloud server.

Exemplarily, the home appliance 101 may be an appliance such as a refrigerator, an air conditioner and a water heater, which is not limited in the present application.

The technical solution of the power consumption monitoring method according to the present application is described in detail below with reference to specific embodiments. The following several specific embodiments may be combined with each other or may exist independently, same or similar concepts or processes may not be repeated in some embodiments, and the embodiments of the present application are described below with reference to the accompanying drawings.

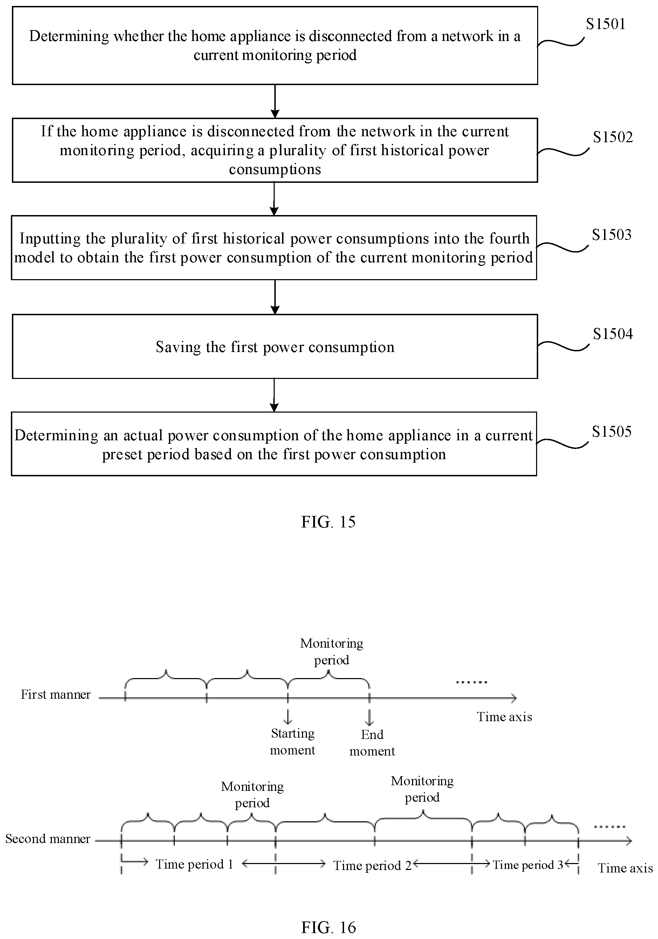

FIG. 15 is a schematic flow diagram of a power consumption monitoring method of a home appliance according to an embodiment of the present application, the method may be executed by a cloud server, as shown in FIG. 15, and the method includes the following steps.

S1501: determining whether the home appliance is disconnected from a network in a current monitoring period.

After the home appliance is powered on and is provided with a networking function, the cloud server can determine whether the home appliance is disconnected from the network in the current monitoring period during operation of the home appliance.

In a possible implementation, the cloud server may send first information to the home appliance, and then monitor whether the home appliance sends an operation parameter, so as to determine whether the home appliance is disconnected from the network. If the cloud server receives the operation parameter sent by the home appliance, the cloud server determines that the home appliance is not disconnected from the network. If the cloud server does not receive the operation parameter sent by the home appliance, the cloud server determines that the home appliance is disconnected from the network.

FIG. 16 is a schematic diagram of a monitoring period during the operation of the home appliance in an example of the embodiment of the present application, and as shown in FIG. 16, the cloud server monitors a power consumption of the home appliance according to the monitoring period in the following two manners.

### First manner

The cloud server may monitor the power consumption of the home appliance according to the monitoring period, for example, the monitoring period may be 30 minutes, or 1 hour or other durations, which is not limited in the present application. Taking the monitoring period as 1 hour as an example, the cloud server may calculate the power consumption of the home appliance in the last hour every 1 hour.

### Second manner

The cloud server can monitor the power consumption of the home appliance according to different monitoring periods in different time periods. Taking the home appliance as a refrigerator as an example, a frequency of use of the refrigerator (for example, a number of times of opening of a door of the refrigerator) by a user is high in 7:00 to 9:00 and 18:00 to 22:00. Exemplarily, the monitoring period in these two time periods may be 30 minutes, and the monitoring period in the other time periods may be 2 hours.

Specifically, the cloud server can determine the time period to which a current moment belongs, and then monitor the power consumption of the home appliance according to the monitoring period corresponding to the time period. By monitoring the power consumption of the home appliance in different time periods according to different monitoring periods, the cloud server can then calculate the power consumptions of different time periods, so as to provide the user with the actual power consumptions of the home appliance within different time periods, so that the user can more finely know a power consumption condition of the home appliance, so as to accurately adjust the use habit of the home appliance according to the power consumption condition, thereby reducing the energy consumption.

S1502: if the home appliance is disconnected from the network in the current monitoring period, acquiring a plurality of first historical power consumptions.

If the home appliance is disconnected from the network in the current monitoring period, the cloud server can obtain the plurality of first historical power consumptions in a preset memory.

In a possible implementation, the plurality of first historical power consumptions may include a predicted power consumption determined by the cloud server based on the power consumption of a monitoring period before the current monitoring period by using the fourth model.

In a possible implementation, any one of the plurality of first historical power consumptions may be determined according to the operation parameter of the home appliance within the corresponding monitoring period. Accuracy can be improved by predicting the first power consumption of the current monitoring period through the plurality of first historical power consumptions.

Exemplarily, the plurality of first historical power consumptions may be power consumptions of a plurality of monitoring periods determined according to the operation parameter of the home appliance in one month previous to the current monitoring period.

S1503: inputting the plurality of first historical power consumptions into the fourth model to obtain the first power consumption of the current monitoring period.

The fourth model is obtained by performing training according to a plurality of second historical power consumptions.

In some embodiments, the cloud server may take the plurality of second historical power consumptions as training data and input the training data into a first preset model for training, so as to obtain the fourth model.

That is, the fourth model is obtained by performing training in advance according to the plurality of second historical power consumptions.

In a possible implementation, the plurality of second historical power consumptions do not include the plurality of first historical power consumptions, the plurality of first historical power consumptions are power consumptions in a latest time period before the current monitoring period, and the plurality of second historical power consumptions may be power consumptions of the home appliance in an earlier stage.

In a possible implementation, the plurality of second historical power consumptions may be obtained as follows: when the home appliance is in a test phase, a tester tests the home appliance according to a home environment where the user is located and the use habit, then collects the power consumptions of the home appliance in a plurality of monitoring periods through a hardware module, and determines the plurality of power consumptions as the plurality of second historical power consumptions. Exemplarily, the hardware power consumption module may be, for example, a smart socket, an electric meter, or the like, with an electricity monitoring function.

It is understood that a large number of first historical power consumptions may be included in the training data, which may improve accuracy of the fourth model.

S1504: saving the first power consumption.

After the first power consumption is obtained, the first power consumption can be stored in the preset memory, so as to facilitate subsequent calculating of the actual power consumption in a preset period.

S1505: determining an actual power consumption of the home appliance in a current preset period based on the first power consumption.

After obtaining the first power consumption, the cloud server may determine the actual power consumption of the home appliance in the current preset period based on the first power consumption. The cloud server can send the actual power consumption of the current preset period to the terminal device of the user or the home appliance, so that the user can know a power consumption condition of the home appliance in the current preset period.

The current preset period includes the current monitoring period. That is, the preset period may include one or more monitoring periods. The cloud server can determine the actual power consumption of the home appliance in the current preset period according to a monitoring period condition included in the preset period.

It can be understood that if the home appliance is still in the network disconnection state in the next monitoring period of the current monitoring period, the first power consumption can be used as a historical power consumption input into the first model in the next monitoring period, so as to predict the power consumption of the next monitoring period.

In this embodiment, the cloud server may determine whether the home appliance is disconnected from the network in the current monitoring period. If yes, the plurality of first historical power consumptions are obtained, and any one of the historical power consumptions is determined according to the operation parameter of the home appliance in the corresponding monitoring period. Then, the plurality of first historical power consumptions are input into the fourth model to obtain the first power consumption of the current monitoring period, and the fourth model is obtained by performing training according to the plurality of second historical power consumptions. The cloud server saves the first power consumption, and then determines the actual power consumption of the home appliance in the current preset period based on the first power consumption. Therefore, the problem that the calculated actual power consumption has a larger deviation due to the loss of the operation parameter during the network disconnection of the home appliance is solved.

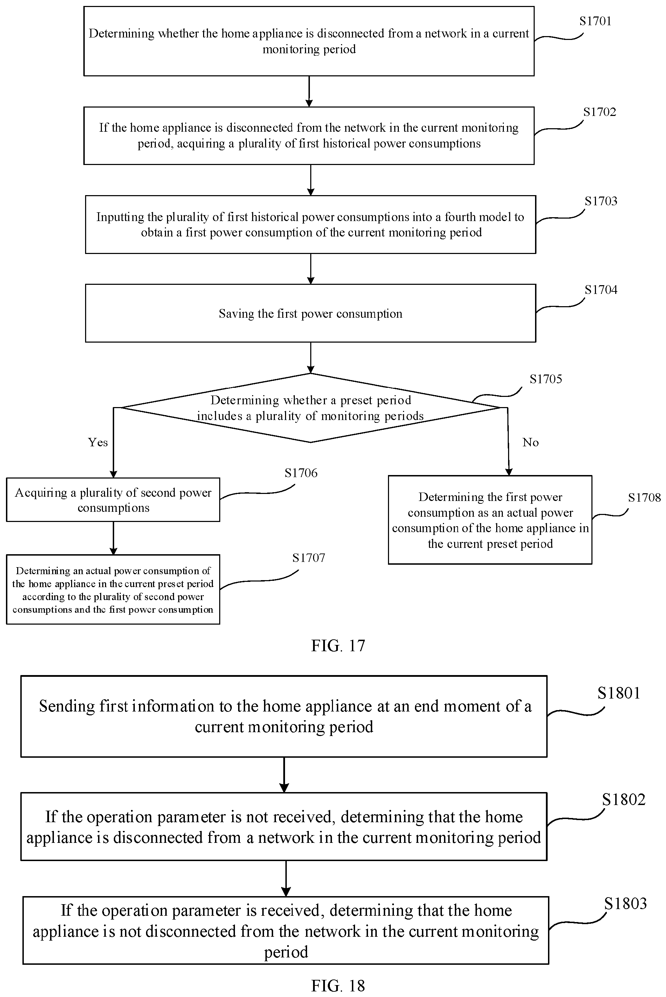

FIG. 17 is a schematic flow diagram of another power consumption monitoring method of a home appliance according to an embodiment of the present application, the method may be executed by a cloud server, as shown in FIG. 17, and the method includes the following steps.

S1701: determining whether the home appliance is disconnected from a network in a current monitoring period.

S1702: if the home appliance is disconnected from the network in the current monitoring period, acquiring a plurality of first historical power consumptions.

S1703: inputting the plurality of first historical power consumptions into a fourth model to obtain a first power consumption of the current monitoring period.

S1704: saving the first power consumption.

For the specific description of the above steps, reference may be made to the above embodiments, which are not repeated herein.

S1705: determining whether a preset period includes a plurality of monitoring periods.

If the preset period includes a plurality of monitoring periods, S406 is performed. It is understood that the plurality of monitoring periods include the current monitoring period.

If the preset period includes one monitoring period, that is, a current preset period is the current monitoring period, S408 is performed.

S1706: acquiring a plurality of second power consumptions.

S1707: determining an actual power consumption of the home appliance in the current preset period according to the plurality of second power consumptions and the first power consumption.

The plural second power consumptions are power consumptions corresponding to monitoring periods except for the current monitoring period in the multiple monitoring periods.

In a possible implementation, the cloud server may add the plurality of second power consumptions and the first power consumption to obtain the actual power consumption of the home appliance in the current preset period.

In a possible implementation, the cloud server may determine, for any one of the plurality of second power consumptions, a preset time period to which the monitoring period corresponding to the second power consumption belongs. The second power consumptions of the monitoring periods belonging to the same preset time period are added to obtain the power consumption of each preset time period. Then, the power consumptions corresponding to the preset time periods are added to obtain the actual power consumption.

Durations of the preset time periods may be the same or different. For example, one time period is 7:00 to 9:00, one time period is 18:00 to 22:00, and the remaining time serves as one time period. Alternatively, one time period is 0:00 to 8:00, one time period is 8:00 to 16:00, and one time period is 16:00 to 0:00. The present application has no limitation in this respect.

In this manner, after the cloud server calculates the actual power consumption, when the electricity information is sent to the terminal device of the user or the home appliance, the electricity information may further include the power consumption of the home appliance in each preset time period.

S1708: determining the first power consumption as an actual power consumption of the home appliance in the current preset period.

In this embodiment, if the preset period includes one monitoring period, the power consumption of the current monitoring period may be determined as the actual power consumption in the preset period. If the preset period includes a plurality of monitoring periods, the actual power consumption in the preset period may be determined according to the power consumptions of the plurality of monitoring periods.

In a possible implementation, after determining the actual power consumption, the cloud server may send the electricity information to the terminal device of the user and/or the home appliance, and the electricity information includes the actual power consumption of the home appliance in the current preset period and the time period corresponding to the actual power consumption.

In a possible implementation, if the cloud server adds the second power consumptions of the monitoring periods belonging to the same preset time period to obtain the power consumption of each preset time period, the electricity information may include the actual power consumption of the home appliance in the current preset period, the time period corresponding to the actual power consumption, and the power consumption of the home appliance in each preset time period.

FIG. 18 is a schematic flow diagram of still another power consumption monitoring method of a home appliance according to an embodiment of the present application, the method may be executed by a cloud server, as shown in FIG. 18, and the method includes the following steps.

S1801: sending first information to the home appliance at an end moment of a current monitoring period.

The first information is used for acquiring an operation parameter of the home appliance in the current monitoring period.

S1802: if the operation parameter is not received, determining that the home appliance is disconnected from a network in the current monitoring period.

S1803: if the operation parameter is received, determining that the home appliance is not disconnected from the network in the current monitoring period.

Exemplarily, after the cloud server sends the first information to the home appliance, within a preset duration, if the operation parameter is not received, the cloud server may determine that the home appliance is disconnected from the network in the current monitoring period. If the operation parameter is received, it may be determined that the home appliance is not disconnected from the network in the current monitoring period.

In a possible implementation, the preset duration can be set based on a maximum time difference from sending of the first information by the cloud server to receiving of the operation parameter sent by the home appliance, so as to avoid that the cloud server receives no operation parameter within the preset duration due to a network transmission speed and misjudges that the home appliance is disconnected from the network.

It can be understood that if the cloud server receives the operation parameter sent by the home appliance, the operation parameter can be stored in the preset memory for subsequent determination of the power consumption.

In this embodiment, at the end moment of each monitoring period, the first information may be sent to the home appliance to request the operation parameter of the home appliance in the monitoring period, and if the operation parameter sent by the home appliance can be received, it may be determined that the network is not disconnected, and if the operation parameter cannot be received, it may be determined that the network is disconnected.

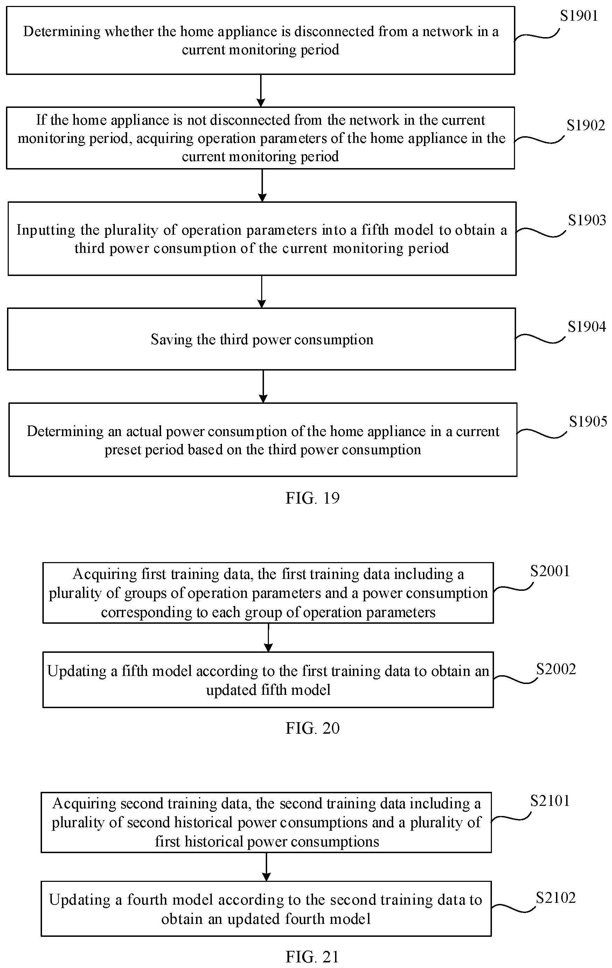

If the home appliance is not disconnected from the network in the current monitoring period, the power consumption of the home appliance in the current monitoring period can be monitored in the following manner shown in FIG. 19.

FIG. 19 is a schematic flow diagram of still another power consumption monitoring method of a home appliance according to an embodiment of the present application, the method may be executed by a cloud server, as shown in FIG. 19, and the method includes the following steps.

S1901: determining whether the home appliance is disconnected from a network in a current monitoring period.

S1902: if the home appliance is not disconnected from the network in the current monitoring period, acquiring operation parameters of the home appliance in the current monitoring period.

S1903: inputting the plurality of operation parameters into a fifth model to obtain a third power consumption of the current monitoring period.

The fifth model is obtained by performing training according to a plurality of groups of historical operation parameters and a power consumption corresponding to each group of historical operation parameters.

In some embodiments, the cloud server may take the plurality of groups of historical operation parameters and the power consumption corresponding to each group of historical operation parameters as training data, each group of historical operation parameters may be used as an input feature, and the corresponding power consumption may be used as a tag.

The training data is input into a second preset model for training to obtain the fifth model.

That is, the fifth model is obtained by performing training in advance according to the plurality of groups of historical operation parameters and the power consumption corresponding to each group of historical operation parameters.

In a possible implementation, the training data may be obtained as follows: when the home appliance is in a test phase, a tester controls operation of the home appliance according to a home environment where a user is located and a use habit, and then acquires the operation parameters of the home appliance in a plurality of monitoring periods and the power consumption corresponding to each group of operation parameters. For example, the power consumption of the home appliance in each monitoring period may be collected through a hardware module, and exemplarily, the hardware power consumption module may be, for example, a smart socket, an electric meter, or the like, with an electricity monitoring function. Then, the operation parameters in the plural monitoring periods and the power consumption corresponding to each group of operation parameters are taken as the training data of the second preset model.

Taking the home appliance as a refrigerator as an example, the operation parameters may include a working power of each load, an operation duration in the current monitoring period, an environment temperature, a set temperature of the refrigerator, or the like.

S1904: saving the third power consumption.

S1905: determining an actual power consumption of the home appliance in a current preset period based on the third power consumption.

For the step that the cloud server determines the actual power consumption of the home appliance in the current preset period based on the third power consumption, reference may be made to the step in the foregoing embodiment that the actual power consumption of the home appliance in the current preset period is determined based on the first power consumption, which is not repeated herein.

It can be understood that, in the current monitoring period, the first power consumption of the home appliance in the network disconnection case and the third power consumption of the home appliance in the network non-disconnection case are approximately the same, that is, have a small difference.

In this embodiment, if the home appliance is not disconnected from the network, the power consumption of the current monitoring period can be calculated according to the operation parameters and the fifth model, so that the power consumption of the home appliance can be prevented from being detected by using hardware structures such as the smart socket or electric meter with an electricity statistics function, and the cost of the home appliance is reduced.

FIG. 20 is a schematic flow diagram of still another power consumption monitoring method of a home appliance according to an embodiment of the present application, the method may be executed by a cloud server, as shown in FIG. 20, and the method includes the following steps.

S2001: acquiring first training data, the first training data including a plurality of groups of operation parameters and a power consumption corresponding to each group of operation parameters.

The multiple groups of operation parameters include operation parameters of a current monitoring period.

S2002: updating a fifth model according to the first training data to obtain an updated fifth model.

Exemplarily, the cloud server may update the fifth model at a preset time interval. Specifically, the cloud server may input the first training data into the fifth model to train the fifth model and obtain the updated fifth model.

The updated fifth model is configured to predict a power consumption of the home appliance in a monitoring period during a network non-disconnection time period.

In this embodiment, the fifth model may be updated to improve accuracy of determining the power consumption by the fifth model.

FIG. 21 is a schematic flow diagram of still another power consumption monitoring method of a home appliance according to an embodiment of the present application, the method may be executed by a cloud server, as shown in FIG. 21, and the method includes the following steps.

S2101: acquiring second training data, the second training data including a plurality of second historical power consumptions and a plurality of first historical power consumptions.

S2102: updating a fourth model according to the second training data to obtain an updated fourth model.

Exemplarily, the cloud server may update the fourth model at a preset time interval. Specifically, the cloud server may input the second training data into the fourth model to train the fourth model and obtain the updated fourth model.

The updated fourth model is configured to predict a power consumption of the home appliance in a monitoring period during a network disconnection time period.

In this embodiment, the fourth model may be updated to improve accuracy of determining the power consumption by the fourth model.

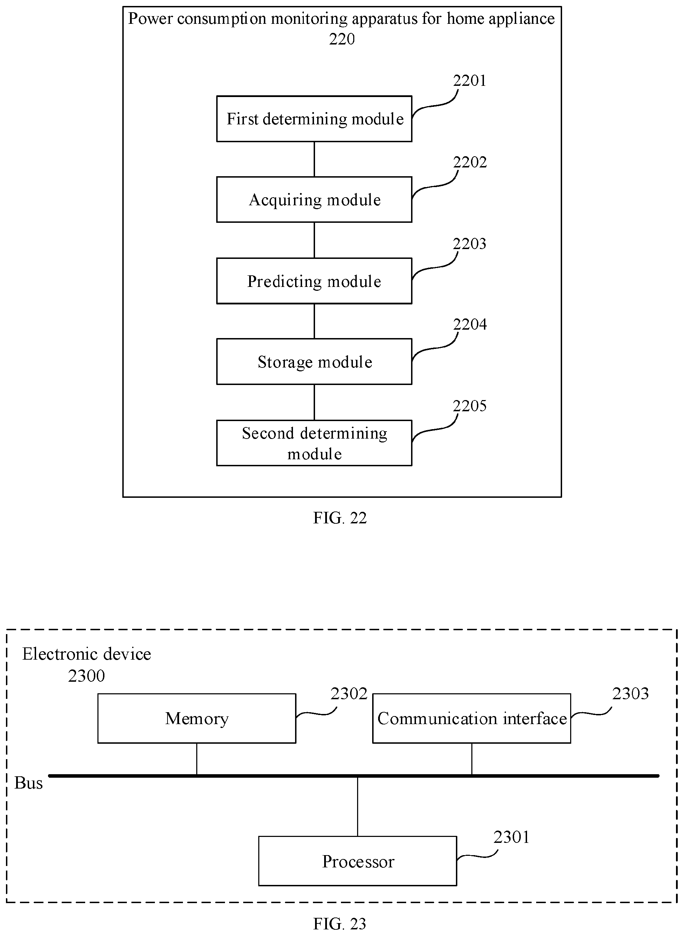

FIG. 22 is a schematic structural diagram of a power consumption monitoring apparatus of a home appliance according to the present application. As shown in FIG. 22, the apparatus 220 includes:
a first determining module 2201 configured to determine whether the home appliance is disconnected from a network in a current monitoring period;
an acquiring module 2202 configured to, if the home appliance is disconnected from the network in the current monitoring period, acquire a plurality of first historical power consumptions;
a predicting module 2203 configured to input the plurality of first historical power consumptions into a fourth model to obtain a first power consumption of the current monitoring period, the fourth model being obtained by performing training according to a plurality of second historical power consumptions;
a storage module 2204 configured to save the first power consumption; and
a second determining module 2205 configured to determine an actual power consumption of the home appliance in a preset period based on the first power consumption, wherein the current preset period includes the current monitoring period.

In a possible implementation, the second determining module 2205 is configured to:
if the current preset period is the current monitoring period, determine the first power consumption as the actual power consumption of the home appliance in the current preset period; and
if the current preset period includes a plurality of monitoring periods, acquire a plurality of second power consumptions, and determine the actual power consumption of the home appliance in the current preset period according to the plurality of second power consumptions and the first power consumption, wherein the plural second power consumptions are power consumptions corresponding to monitoring periods except for the current monitoring period in the multiple monitoring periods.

In a possible implementation, the first determining module 2201 is configured to:
send first information to the home appliance at an end moment of the current monitoring period, the first information being used for acquiring an operation parameter of the home appliance in the current monitoring period;
if the operation parameter is not received, determine that the home appliance is disconnected from the network in the current monitoring period; and
if the operation parameter is received, determine that the home appliance is not disconnected from the network in the current monitoring period.

In a possible implementation, the apparatus 220 further includes an online predicting module configured to:
if it is determined that the home appliance is not disconnected from the network in the current monitoring period, input the operation parameter of the home appliance in the current monitoring period into a fifth model to obtain a third power consumption of the current monitoring period, wherein the fifth model is obtained by performing training according to a plurality of groups of historical operation parameters and a power consumption corresponding to each group of historical operation parameters;
save the third power consumption; and
determine the actual power consumption of the home appliance in the current preset period based on the third power consumption.

In a possible implementation, the apparatus 220 further includes a first training module configured to:
acquire first training data, the first training data including a plurality of groups of operation parameters and a power consumption corresponding to each group of operation parameters, wherein the plurality of groups of operation parameters include the operation parameters of the current monitoring period; and
update the fifth model according to the first training data to obtain an updated fifth model, the updated fifth model being configured to predict a power consumption of the home appliance in a monitoring period during a network non-disconnection time period.

In a possible implementation, the apparatus 220 further includes a second training module configured to:
acquire second training data, the second training data including a plurality of second historical power consumptions and a plurality of first historical power consumptions; and
update the fourth model according to the second training data to obtain an updated fourth model, the updated fourth model being configured to predict a power consumption of the home appliance in a monitoring period during a network disconnection time period.

In a possible implementation, the apparatus 220 further includes a sending module configured to:
send electricity information to a terminal device of a user and/or the home appliance, the electricity information including the actual power consumption of the home appliance in the current preset period and a time period corresponding to the actual power consumption.

The power consumption monitoring apparatus of a home appliance according to the embodiment of the present application can execute the power consumption monitoring method of a home appliance according to the method embodiment, and an implementation principle and a technical effect are similar, which are not repeated herein.

It should be noted that the division of the modules shown in FIG. 22 is merely an illustration, and the present application has no limitations on the division of the modules and the naming of the modules. The modules in the apparatus may be wholly or partially implemented by software, hardware and a combination thereof. The modules may be embedded in or independent of a processor in a computer device in hardware, or may be stored in a memory in the computer device in software, such that the processor can conveniently call the modules to execute the operations corresponding to the modules.

FIG. 23 is a schematic structural diagram of an electronic device according to an embodiment of the present application, and as shown in the drawing, the electronic device 2300 may include: at least one processor 2301 and a memory 2302.

The memory 2302 is configured to store a program. The program may include program codes including computer operation instructions.

The memory 2302 may include a random access memory (RAM) or a non-transitory memory such as at least one disk memory.

The processor 2301 is configured to execute the computer operation instructions stored by the memory 2302 to implement the method according to the aforementioned method embodiment. The processor 2301 may be a central processing unit (CPU), an application specific integrated circuit (ASIC), or one or more integrated circuits configured to implement embodiments of the present application.

In some embodiments, the electronic device 2300 may further include: a communication interface 2303. In particular implementation, if the communication interface 2303, the memory 2302, and the processor 2301 are implemented independently, the communication interface 2303, the memory 2302, and the processor 2301 may be connected to each other and perform communication with each other through a bus. The bus may be an industry standard architecture (ISA) bus, a peripheral component interconnect (PCI) bus, an extended ISA (EISA) bus, or the like. The bus may include an address bus, a data bus, a control bus, or the like, but does not indicate only one bus or one type of buses.

In specific implementation, if the communication interface 2303, the memory 2302, and the processor 2301 are integrated into one chip, the communication interface 2303, the memory 2302, and the processor 2301 can complete communication through an internal interface.

The electronic device 2300 may be a cloud server, or the like.

The electronic device according to this embodiment may be configured to execute the technical solution shown in the foregoing method embodiment, and the specific implementation and the technical effects are similar, and are not repeated herein.

The present application further provides a computer-readable storage medium, which may include: various media that can store program codes, such as a USB flash disk, a mobile hard disk, a read-only memory (ROM), an RAM, a magnetic disk, or an optical disk, and specifically, the computer-readable storage medium stores computer execution instructions, and the computer execution instructions, when executed by a computer, implement the technical solution shown in the above method embodiment.

The present application further provides a program product, including execution instructions, the execution instructions being stored in a computer-readable storage medium, and when executed by a computer, executing the technical solution shown in the foregoing method embodiment. The specific implementation and the technical effects are similar, and are not repeated herein.

Finally, it should be noted that the above embodiments are only used to illustrate the technical solutions of the present disclosure, not to limit the present disclosure; although the present disclosure is described in detail with reference to the above embodiments, those having ordinary skill in the art should understand that they still can modify technical solutions recited in the aforesaid embodiments or equivalently replace partial or all technical features therein; these modifications or substitutions do not make essence of corresponding technical solutions depart from the scope of the technical solutions of the embodiments of the present disclosure.

## Claims

1. A refrigerator, comprising:
a plurality of functional components; and
a processing apparatus configured to:
on the basis of refrigerator operation condition information, use a preconfigured first model to determine a first energy-saving operation parameter value of at least one first functional component corresponding to the refrigerator operation condition information;
replace an actual operation parameter value corresponding to a first energy-saving operation parameter in the refrigerator operation condition information with the first energy-saving operation parameter value determined by the first model, so as to generate refrigerator energy-saving operation condition information;
on the basis of the refrigerator energy-saving operation condition information, use a preconfigured second model to determine a second energy-saving operation parameter value of at least one second functional component corresponding to the refrigerator energy-saving operation condition information; and
drive operation of the first functional component on the basis of the first energy-saving operation parameter value, and drive operation of the second functional component on the basis of the second energy-saving operation parameter value.

2. The refrigerator according to claim 1,
wherein the first functional component comprises a compressor;
the processing apparatus is configured to, on the basis of the refrigerator operation condition information, determine a first energy-saving operation parameter value of at least one compressor corresponding to the refrigerator operation condition information according to the preconfigured first model.

3. The refrigerator according to claim 2,
wherein the second functional component comprises a fan;
the processing apparatus is further configured to:
replace an actual operation parameter value corresponding to the first energy-saving operation parameter value of the compressor in the refrigerator operation condition information with the first energy-saving operation parameter value determined by the first model, so as to generate refrigerator energy-saving operation condition information;
on the basis of the refrigerator energy-saving operation condition information, use the preconfigured second model to determine a second energy-saving operation parameter value of the fan corresponding to the refrigerator energy-saving operation condition information; and
drive operation of the compressor on the basis of the first energy-saving operation parameter value, and drive operation of the fan on the basis of the second energy-saving operation parameter value.

4. The refrigerator according to claim 2,
wherein the second functional component comprises a defrosting heater;
the processing apparatus is configured to: replace an actual operation parameter value corresponding to the first energy-saving operation parameter value of the compressor in the refrigerator operation condition information with the first energy-saving operation parameter determined by the first model, so as to generate refrigerator energy-saving operation condition information;
on the basis of the refrigerator energy-saving operation condition information, use the preconfigured second model to determine a second energy-saving operation parameter value of the defrosting heater corresponding to the refrigerator energy-saving operation condition information; and
drive operation of the compressor on the basis of the first energy-saving operation parameter value, and drive operation of the defrosting heater on the basis of the second energy-saving operation parameter value.

5. The refrigerator according to claim 2,
wherein the second functional components comprise a fan and a defrosting heater;
the processing apparatus is configured to:
replace an actual operation parameter value corresponding to a first energy-saving operation parameter of the compressor in the refrigerator operation condition information with the first energy-saving operation parameter value determined by the first model, so as to generate refrigerator energy-saving operation condition information;
on the basis of the refrigerator energy-saving operation condition information, use the preconfigured second model to determine a second energy-saving operation parameter of the fan corresponding to the refrigerator energy-saving operation condition information; and on the basis of the refrigerator energy-saving operation condition information, use a preconfigured third model to determine a second energy-saving operation parameter of the defrosting heater corresponding to the refrigerator energy-saving operation condition information; and
drive operation of the compressor on the basis of the first energy-saving operation parameter, drive operation of the fan on the basis of the second energy-saving operation parameter of the fan, and drive operation of the defrosting heater on the basis of the second energy-saving operation parameter of the defrosting heater.

6. The refrigerator according to claim 4 or 5,
wherein the second energy-saving operation parameter of the defrosting heater comprises a defrosting heating coefficient; the defrosting heating coefficient represents a working state time ratio of the defrosting heater in a set period.

7. A refrigerator, comprising:
a compressor;
a fan;
a defrosting heater; and
a processing apparatus configured to:
acquire refrigerator operation condition information, acquire a working state of the compressor, and confirm whether the working state of the compressor is valid;
when the working state of the compressor is valid, on the basis of the refrigerator operation condition information, use a preconfigured first model to determine a first energy-saving operation parameter of at least one compressor corresponding to the refrigerator operation condition information, and correct an operation parameter of the defrosting heater to a first preset value;
replace an actual operation parameter value corresponding to the first energy-saving operation parameter of the compressor in the refrigerator operation condition information with the first energy-saving operation parameter determined by the first model, so as to generate refrigerator energy-saving operation condition information;
on the basis of the refrigerator energy-saving operation condition information, use a preconfigured second model to determine a second energy-saving operation parameter of at least one fan corresponding to the refrigerator energy-saving operation condition information; and
drive operation of the compressor on the basis of the first energy-saving parameter, drive operation of the fan on the basis of the second energy-saving operation parameter, and drive operation of the defrosting heater on the basis of the first preset value.

8. The refrigerator according to claim 7,
wherein the processing apparatus is further configured to:
when the working state of the compressor is invalid, respectively correct an operation parameter of the compressor and an operation parameter of the fan to a second preset value and a third preset value;
acquire the refrigerator operation condition information, acquire a working state of the defrosting heater, and confirm whether the working state of the defrosting heater is valid;
when the working state of the defrosting heater is valid, on the basis of the refrigerator energy-saving operation condition information, use a preconfigured third model to determine a second energy-saving operation parameter of at least one defrosting heater corresponding to the refrigerator energy-saving operation condition information; and
drive the operation of the compressor on the basis of the second preset value, drive the operation of the fan on the basis of the third preset value, and drive the operation of the defrosting heater on the basis of the second energy-saving operation parameter of the defrosting heater.

9. The refrigerator according to claim 8, wherein the processing apparatus is configured to:
when the working state of the defrosting heater is invalid, correct the operation parameter of the defrosting heater to the first preset value;
drive the operation of the compressor on the basis of the second preset value, drive the operation of the fan on the basis of the third preset value, and drive the operation of the defrosting heater on the basis of the first preset value.

10. The refrigerator according to claim 9,
wherein the second energy-saving operation parameter of the defrosting heater comprises a defrosting heating coefficient; the defrosting heating coefficient represents a working state time ratio of the defrosting heater in a set period.

11. A power consumption monitoring method of a home appliance, which is applied to a cloud server, the method comprising:
determining whether the home appliance is disconnected from a network in a current monitoring period;
if the home appliance is disconnected from the network in the current monitoring period, acquiring a plurality of first historical power consumptions;
inputting the plurality of first historical power consumptions into a fourth model to obtain a first power consumption of the current monitoring period, the fourth model being obtained by performing training according to a plurality of second historical power consumptions;
saving the first power consumption; and
determining an actual power consumption of the home appliance in a current preset period based on the first power consumption, wherein the current preset period comprises the current monitoring period.

12. The method according to claim 11, wherein determining the actual power consumption of the home appliance in the current preset period based on the first power consumption comprises:
if the current preset period is the current monitoring period, determining the first power consumption as the actual power consumption of the home appliance in the current preset period; and
if the current preset period comprises a plurality of monitoring periods, acquiring a plurality of second power consumptions, and determining the actual power consumption of the home appliance in the current preset period according to the plurality of second power consumptions and the first power consumption, wherein the plural second power consumptions are power consumptions corresponding to monitoring periods except for the current monitoring period in the plural monitoring periods.

13. The method according to claim 11 or 12, wherein determining whether the home appliance is disconnected from the network in the current monitoring period comprises:
sending first information to the home appliance at an end moment of the current monitoring period, the first information being used for acquiring an operation parameter of the home appliance in the current monitoring period; if the operation parameter is not received, determining that the home appliance is disconnected from the network in the current monitoring period; and
if the operation parameter is received, determining that the home appliance is not disconnected from the network in the current monitoring period.

14. The method according to claim 11, further comprising:
if it is determined that the home appliance is not disconnected from the network in the current monitoring period, inputting an operation parameter of the home appliance in the current monitoring period into a fifth model to obtain a third power consumption of the current monitoring period, wherein the fifth model is obtained by performing training according to a plurality of groups of historical operation parameters and a power consumption corresponding to each group of historical operation parameters;
saving the third power consumption; and
determining the actual power consumption of the home appliance in the current preset period based on the third power consumption.

15. The method according to claim 14, further comprising:
acquiring first training data, the first training data comprising a plurality of groups of operation parameters and a power consumption corresponding to each group of operation parameters, wherein the plurality of groups of operation parameters comprise the operation parameters of the current monitoring period; and
updating the fifth model according to the first training data to obtain an updated fifth model, the updated fifth model being configured to predict a power consumption of the home appliance in a monitoring period during a network non-disconnection time period.

16. The method according to claim 11, further comprising:
acquiring second training data, the second training data comprising a plurality of second historical power consumptions and a plurality of first historical power consumptions; and
updating the fourth model according to the second training data to obtain an updated fourth model, the updated fourth model being configured to predict a power consumption of the home appliance in a monitoring period during a network disconnection time period.

17. The method according to any one of claims 11 to 14, further comprising:
sending electricity information to a terminal device of a user and/or the home appliance, the electricity information comprising the actual power consumption of the home appliance in the current preset period and a time period corresponding to the actual power consumption.

18. A power consumption monitoring apparatus of a home appliance, comprising:
a first determining module configured to determine whether the home appliance is disconnected from a network in a current monitoring period;
an acquiring module configured to, if the home appliance is disconnected from the network in the current monitoring period, acquire a plurality of first historical power consumptions;
a predicting module configured to input the plurality of first historical power consumptions into a fourth model to obtain a first power consumption of the current monitoring period, the fourth model being obtained by performing training according to a plurality of second historical power consumptions;
a storage module configured to save the first power consumption; and
a second determining module configured to determine an actual power consumption of the home appliance in a current preset period based on the first power consumption, wherein the current preset period comprises the current monitoring period.

19. An electronic device, comprising: a processor and a memory communicatively connected to the processor;
the memory storing computer execution instructions;
the processor is configured to execute the computer execution instructions stored by the memory to implement the method according to any one of claims 11 to 17.
